# EUROPEAN PATENT SPECIFICATION

(11) **EP 3 540 805 B1**
(45) Date of publication and mention of the grant of the patent: **23.11.2022**
(21) Application number: 17870255.1
(22) Date of filing: 14.11.2017
(51) Int. Cl.: H01L 51/54, C07F 15/00, C09K 11/06, H01L 51/00

(54) **LIGHT EMITTING ELEMENT, AND METAL COMPLEX AND COMPOSITION USED IN SAME**
LICHTEMITTIERENDES ELEMENT SOWIE METALLKOMPLEX UND ZUSAMMENSETZUNG, DIE DARIN VERWENDET WERDEN
ÉLÉMENT ÉLECTROLUMINESCENT, ET COMPLEXE MÉTALLIQUE ET COMPOSITION UTILISÉE DANS CELUI-CI

(30) Priority: 14.11.2016 JP 2016221825
(43) Date of publication of application: 18.09.2019
(73) Proprietor: Sumitomo Chemical Company, Limited, Tokyo 103-6020 (JP); Cambridge Display Technology Limited, Cardinal Way Godmanchester Cambridgeshire PE29 2XG (GB)
(72) Inventor: SASADA Toshiaki, Tsukuba-shi, Ibaraki 300-3294 (JP); TSUBATA Yoshiaki, Tsukuba-shi, Ibaraki 300-3294 (JP); TARRAN William, Godmanchester, Cambridgeshire PE29 2XG (GB); KAMTEKAR Kiran Timothy, Godmanchester, Cambridgeshire PE29 2XG (GB)
(74) Representative: J A Kemp LLP
(86) International application number: PCT/JP2017/040990
(87) International publication number: WO 2018/088573

(56) References cited:
- EP-A1- 3 410 508
- WO-A1-2013/058087
- WO-A1-2016/185183
- WO-A1-2017/170916
- JP-A- 2012 046 492
- JP-A- 2013 016 610
- JP-A- 2013 016 610
- JP-A- 2013 145 811
- US-A1- 2015 349 267
- US-A1- 2015 349 267
- US-A1- 2016 049 598
- US-A1- 2016 049 598

## Description

### Technical Field

The present invention relates to a light emitting device, and a metal complex and a composition used in the light emitting device.

### Background Art

Light emitting devices such as organic electroluminescent devices can be suitably used for display and lighting applications, and research and development into such devices is being carried out. For example, Patent Literature 1 discloses a light emitting device comprising a light emitting layer comprising Metal Complex 1 represented by the following formula.

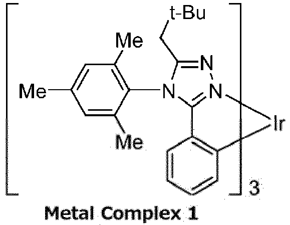

Patent Literature 2 discloses a composition in which a phosphorescent compound and a host material are blended with each other, wherein the amount of chlorine atoms contained as impurities in the phosphorescent compound is 3.5 ppm by mass or less with respect to the total amount of solid contents blended in the composition.

Patent Literature 3 discloses a compound having formula:

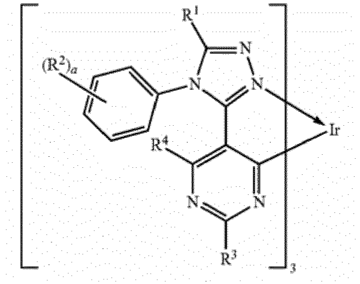

Patent Literature 4 discloses a compound having formula:

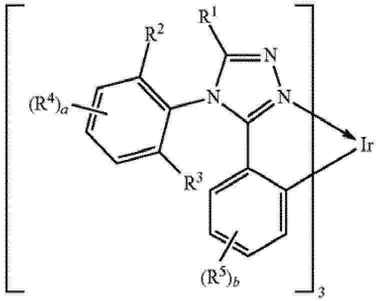

Patent Literature 5 discloses an organic electroluminescent element compirsing at least one compound having formula:

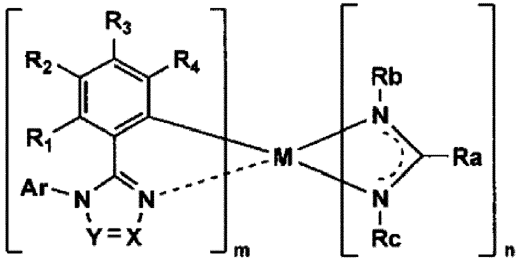

Patent Literature 6 discloses a copolymer which can be used as a semiconductor material, and is used for manufacturing a photoelectric conversion element.

### Citation List

### Patent Literature

[Patent Literature 1]
   Japanese Unexamined Patent Publication No. 2011-253980
[Patent Literature 2]
   EP 3 410 508 A1
[Patent Literature 3]
   US 2016/049598 A1
[Patent Literature 4]
   US 2015/349267 A1
[Patent Literature 5]
   JP 2013 016610 A
[Patent Literature 6]
   JP 2013 145811 A

### Summary of Invention

### Technical Problem

However, the light emitting device of Patent Literature 1 described above does not always exhibit a sufficient luminance lifetime.

Therefore, it is an object of the present invention to provide a light emitting device which shows an excellent luminance lifetime. Further, it is another object of the present invention to provide a metal complex and a composition which are useful for the production of a light emitting device which shows an excellent luminance lifetime.

### Solution to Problem

The present invention is defined in the appended claims 1-9.

### Advantageous Effects of Invention

According to the present invention, a light emitting device which shows an excellent luminance lifetime can be provided. Moreover, according to the present invention, a metal complex and a composition useful for producing a light emitting device which shows an excellent luminance lifetime can be provided.

### Description of Embodiments

Preferable embodiments of the present invention will now be described in detail.

### <Description of Common Terms>

Unless otherwise stated, terms commonly used in the present specification have the following meanings.

Me represents a methyl group, Et represents an ethyl group, Bu represents a butyl group, i-Pr represents an isopropyl group, and t-Bu represents a tert-butyl group.

The hydrogen atom may be a heavy hydrogen atom or a light hydrogen atom.

In the formula representing a metal complex, a solid line representing a bond to the central metal represents a covalent bond or a coordinate bond.

The term "polymer compound" means a polymer having molecular weight distribution and having a polystyrene-equivalent number-average molecular weight of 1 × 10³ or more (for example, 1 × 10³ to 1 × 10⁸).

The polymer compound may be any of a block copolymer, a random copolymer, an alternating copolymer, and a graft copolymer, or may even be some other form.

If a polymerization active group remains intact at the terminal group of the polymer compound, light emitting properties or luminance lifetime may deteriorate if such a polymer compound is used to fabricate the light emitting device, and therefore, it is preferable that the terminal group be a stable group. The terminal group of the polymer compound is preferably a group covalently bonded to the main chain, and examples thereof include groups bonding to an aryl group or a monovalent heterocyclic group bonded to the main chain of the polymer compound via a carbon-carbon bond.

The term "low molecular weight compound" means a compound that does not have a molecular weight distribution and that has a molecular weight of 1 × 10⁴ or less.

The term "constitutional unit" means a unit occurring one or more times in a polymer compound.

The "alkyl group" may be either linear or branched. The linear alkyl group usually has 1 to 50 carbon atoms, preferably 1 to 30 carbon atoms, more preferably 1 to 15 carbon atoms, and further preferably 1 to 10, not including the carbon atoms of the substituent. The branched alkyl group usually has 3 to 50 carbon atoms, preferably 3 to 30 carbon atoms, more preferably 3 to 15 carbon atoms, and further preferably 3 to 10, not including the carbon atoms of the substituent.

The alkyl group may have a substituent. Examples of the alkyl group include a methyl group, an ethyl group, a propyl group, an isopropyl group, a butyl group, a 2-butyl group, an isobutyl group, a tert-butyl group, a pentyl group, an isoamyl group, 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group, and a dodecyl group. In addition, the alkyl group may be a group obtained by substituting a part of or all of hydrogen atoms of these groups with a cycloalkyl group, an alkoxy group, a cycloalkoxy group, an aryl group, a fluorine atom, and the like. Examples of such an alkyl group includes a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-hexylphenyl)propyl group, and a 6-ethyloxyhexyl group.

The "cycloalkyl group" usually has 3 to 50 carbon atoms, preferably 3 to 30 carbon atoms, and more preferably 4 to 20 carbon atoms, not including the carbon atoms of the substituent.

The cycloalkyl group may have a substituent. Examples of the cycloalkyl group include a cyclohexyl group, a cyclohexylmethyl group, and a cyclohexylethyl group.

The term "aryl group" means the atomic group remaining after removing from an aromatic hydrocarbon one hydrogen atom that is directly bonded to a carbon atom constituting the ring. The aryl group usually has 6 to 60 carbon atoms, preferably 6 to 20 carbon atoms, and more preferably 6 to 10 carbon atoms, not including the carbon atoms of the substituent.

The aryl group may have a substituent. Examples of the aryl group include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group, and a 4-phenylphenyl group. In addition, the aryl group may be a group obtained by substituting a part of or all of hydrogen atoms of these groups with an alkyl group, a cycloalkyl group, an alkoxy group, a cycloalkoxy group, an aryl group, a fluorine atom, and the like.

The "alkoxy group" may be any of linear and branched. The linear alkoxy group usually has 1 to 40 carbon atoms, and preferably 4 to 10 carbon atoms, not including the carbon atoms of the substituent. The branched alkoxy group usually has 3 to 40 carbon atoms, and preferably 4 to 10 carbon atoms, not including the carbon atoms of the substituent.

The alkoxy group may have a substituent. Examples of the alkoxy group include a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group, and a lauryloxy group. In addition, the alkoxy group may be a group obtained by substituting a part of or all of hydrogen atoms of these groups with a cycloalkyl group, an alkoxy group, a cycloalkoxy group, an aryl group, a fluorine atom, and the like.

The "cycloalkoxy group" usually has 3 to 40 carbon atoms, and preferably 4 to 10 carbon atoms, not including the carbon atoms of the substituent.

The cycloalkoxy group may have a substituent. Examples of the cycloalkoxy group include a cyclohexyloxy group.

The "aryloxy group" usually has 6 to 60 carbon atoms, and preferably 6 to 48, not including the carbon atoms of the substituent.

The aryloxy group may have a substituent. Examples of the aryloxy group include a phenoxy group, a 1-naphthyloxy group, a 2-naphthyloxy group, a 1-anthracenyloxy group, a 9-anthracenyloxy group, and a 1-pyrenyloxy group. In addition, the aryloxy group may be a group obtained by substituting a part of or all of hydrogen atoms of these groups with an alkyl group, a cycloalkyl group, an alkoxy group, a cycloalkoxy group, a fluorine atom, and the like.

The term "p-valent heterocyclic group" (p represents an integer of 1 or more) means an atomic group remaining after removing from a heterocyclic compound p atoms of hydrogen among the hydrogen atoms that are directly bonded to carbon atoms or hetero atoms constituting the ring. Among p-valent heterocyclic groups, preferable are the "p-valent aromatic heterocyclic groups", which are the atomic groups remaining after p atoms of hydrogen among the hydrogen atoms directly bonded to carbon atoms or hetero atoms constituting the ring are removed from an aromatic heterocyclic compound.

The term "aromatic heterocyclic compound" means, for example, a compound in which the heterocyclic ring itself exhibits aromaticity, such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzophosphole, and the like, or a compound in which an aromatic ring is condensed to a heterocyclic ring even if the heterocyclic ring itself does not exhibit aromaticity, such as phenoxazine, phenothiazine, dibenzoborole, dibenzosilole, benzopyran, and the like.

The monovalent heterocyclic group usually has 2 to 60 carbon atoms, and preferably 4 to 20 carbon atoms, not including the carbon atoms of the substituent.

The monovalent heterocyclic group may have a substituent. Examples of the monovalent heterocyclic group include a thienyl group, a pyrrolyl group, a furyl group, a pyridyl group, a piperidinyl group, a quinolinyl group, an isoquinolinyl group, a pyrimidinyl group, and a triazinyl group. In addition, the monovalent heterocyclic group may be a group obtained by substituting a part of or all of hydrogen atoms of these groups with an alkyl group, a cycloalkyl group, an alkoxy group, and a cycloalkoxy group.

The term "halogen atom" means a fluorine atom, a chlorine atom, a bromine atom, or an iodine atom.

An "amino group" may have a substituent, and a substituted amino group is preferable. As the substituent that the amino group has, an alkyl group, a cycloalkyl group, an aryl group, or a monovalent heterocyclic group is preferable.

The substituted amino group is preferably a disubstituted amino group. Examples of the disubstituted amino group include a dialkylamino group, a dicycloalkylamino group, and a diarylamino group.

Examples of the disubstituted amino group include a dimethylamino group, a diethylamino group, a diphenylamino group, a bis(4-methylphenyl)amino group, a bis(4-tert-butylphenyl)amino group, and a bis(3,5-di-tert-butylphenyl)amino group.

An "alkenyl group" may be any of linear and branched. The linear alkenyl group usually has 2 to 30 carbon atoms, and preferably 3 to 20 carbon atoms, not including the carbon atoms of the substituent. The branched alkenyl group usually has carbon atoms 3 to 30, and preferably 4 to 20 carbon atoms, not including the carbon atoms of the substituent.

A "cycloalkenyl group" usually has 3 to 30 carbon atoms, and preferably 4 to 20 carbon atoms, not including the carbon atoms of the substituent.

The alkenyl group and the cycloalkenyl group may each have a substituent. Examples of the alkenyl group include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group, a 7-octenyl group, and groups obtained by substituting a part of or all of hydrogen atoms of these groups with a substituent. Examples of the cycloalkenyl group include a cyclohexenyl group, a cyclohexadienyl group, a cyclooctatrienyl group, a norbonylenyl group, and groups obtained by substituting a part of or all of hydrogen atoms of these groups with a substituent.

An "alkynyl group" may be any of linear and branched. The alkynyl group usually has 2 to 20 carbon atoms, and preferably 3 to 20 carbon atoms, not including the carbon atoms of the substituent. The branched alkynyl group usually has 4 to 30 carbon atoms, and preferably 4 to 20 carbon atoms, not including the carbon atoms of the substituent.

A "cycloalkynyl group" usually has 4 to 30 carbon atoms, and preferably 4 to 20 carbon atoms, not including the carbon atoms of the substituent.

The alkynyl group and the cycloalkynyl group may each have a substituent. Examples of the alkynyl group include an ethynyl group, a 1-propynyl group, a 2-propynyl group, a 2-butynyl group, a 3-butynyl group, a 3-pentynyl group, a 4-pentynyl group, a 1-hexynyl group, a 5-hexynyl group, and groups obtained by substituting a part of or all of hydrogen atoms of these groups with a substituent. Examples of the cycloalkynyl group include a cyclooctynyl group.

An "arylene group" means an atomic group remaining after removing from an aromatic hydrocarbon two hydrogen atoms that are directly bonded to a carbon atom constituting the ring. The arylene group usually has 6 to 60 carbon atoms, preferably 6 to 30 carbon atoms, and more preferably 6 to 18 carbon atoms, not including the carbon atoms of the substituent.

The arylene group may have a substituent. Examples of the arylene group include a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group, a chrysenediyl group, and groups obtained by substituting a part of or all of hydrogen atoms of these groups with a substituent. The arylene group is preferably groups represented by formula (A-1) to formula (A-20). The arylene group may be a group obtained by bonding a plurality of these groups.

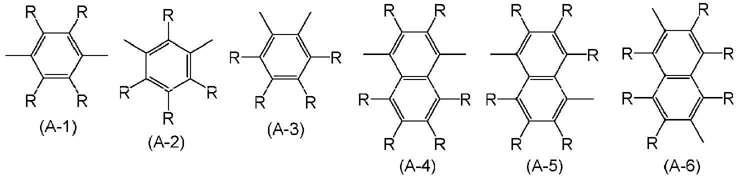

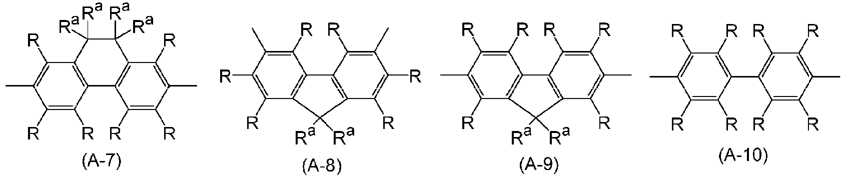

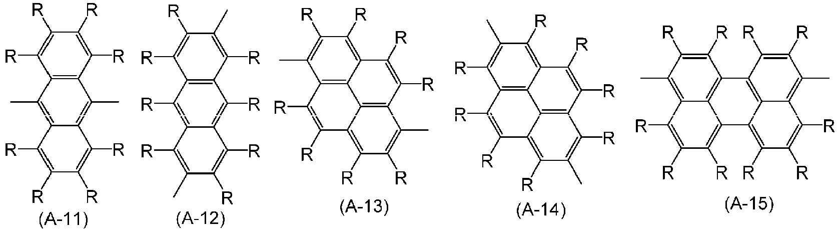

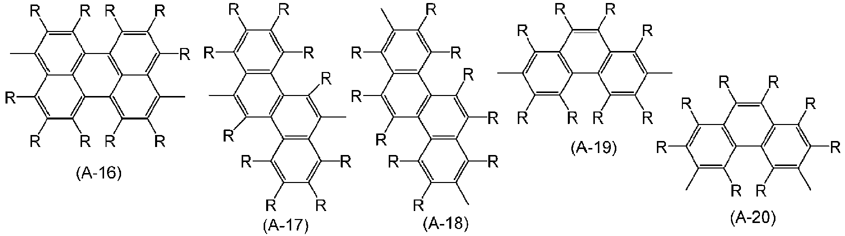

In the formulas, R and R^{a} each independently represent a hydrogen atom, an alkyl group, a cycloalkyl group, an alkoxy group, a cycloalkoxy group, an aryl group or a monovalent heterocyclic group, and preferable are a hydrogen atom, an alkyl group, a cycloalkyl group, an aryl group or a monovalent heterocyclic group. The plurality of R and R^{a} may be the same or different at each occurrence; and the plurality of R^{a} may be bonded to each other to form a ring together with the atoms to which they are bonded.

The divalent heterocyclic group usually has 2 to 60 carbon atoms, preferably 3 to 20 carbon atoms, and more preferably 4 to 15 carbon atoms, not including the carbon atoms of the substituent.

The divalent heterocyclic group may have a substituent. Examples of the divalent heterocyclic group include divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole and triazole two hydrogen atoms among the hydrogen atoms directly bonded to a carbon atom or a hetero atom constituting the ring. In addition, the divalent heterocyclic group may be a group obtained by substituting a part of or all of hydrogen atoms of these groups with a substituent. The divalent heterocyclic group is preferably groups represented by formula (AA-1) to formula (AA-34). The divalent heterocyclic group may be a group obtained by bonding a plurality of these groups.

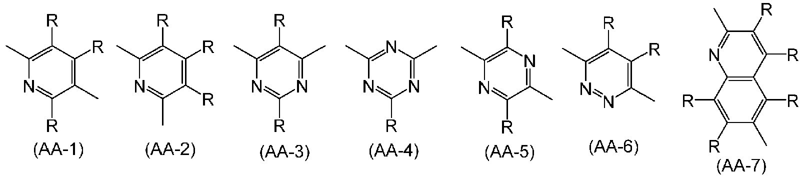

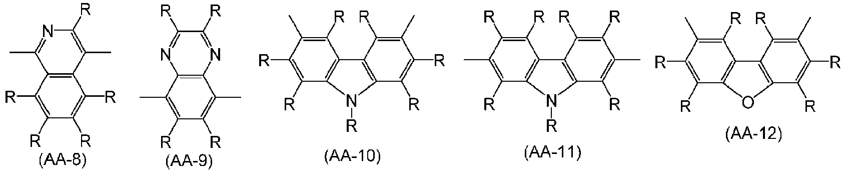

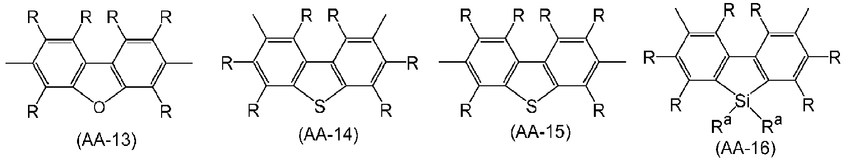

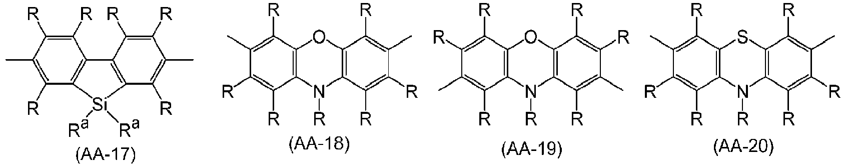

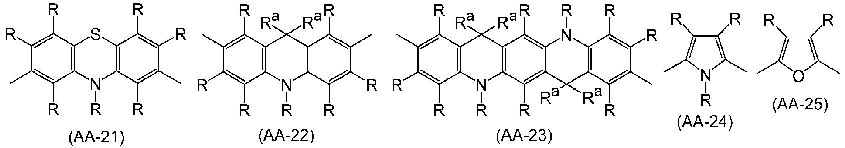

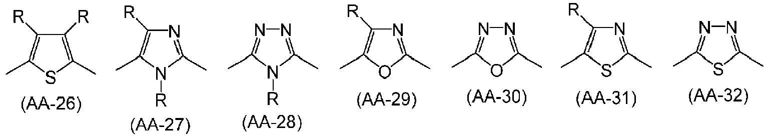

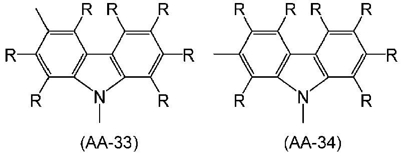

In the formulas, R and R^{a} represent the same meanings as described above.

The term "crosslinkable group" means a group capable of producing a new bond when subjected to heat treatment, UV-irradiation treatment, near-UV irradiation treatment, visible light irradiation treatment, infrared irradiation treatment, a radical reaction, and the like. The crosslinkable group is preferably a crosslinkable group represented by any of formula (B-1) to formula (B-17). These groups may each have a substituent.

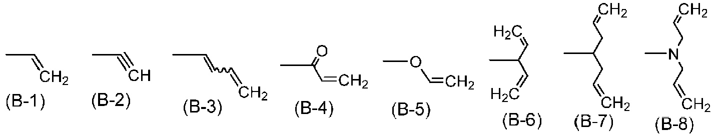

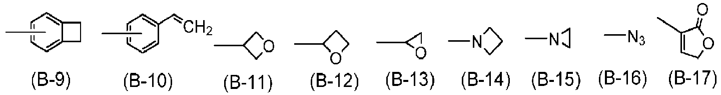

The term "substituent" represents a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group, or a cycloalkynyl group. The substituent may also be a crosslinkable group.

### <Light Emitting Device>

The light emitting device of the present embodiment comprises an anode, a cathode, a light emitting layer provided between the anode and the cathode. Moreover, in the light emitting device of the present embodiment, the light emitting layer comprises a metal complex represented by formula (1).

### <Light Emitting Layer>

The light emitting layer is a layer comprising a metal complex represented by formula (1). The light emitting layer may also comprise a single metal complex represented by formula (1), or may comprise two or more.

Examples of the method for forming the light emitting layer include a dry method such as a vacuum evaporation method, and a wet method such as spin coating and an ink jet printing, and a wet method is preferable.

When the light emitting layer is formed by a wet method, it is preferable to use an ink of the light emitting layer, which is described later.

### <Metal Complex Represented by Formula (1)>

The metal complex represented by formula (1) is usually a metal complex that exhibits phosphorescence at room temperature (25°C), and is preferably a metal complex that exhibits luminescence from a triplet excited state at room temperature.

The metal complex represented by formula (1) contains M, which is a central metal, a ligand whose number is defined by the suffix n¹, and a ligand whose number is defined by the suffix n².

M is preferably an iridium atom or a platinum atom, and more preferably an iridium atom, because the luminance lifetime of the light emitting device of the present embodiment is better.

When M is a rhodium atom or an iridium atom, n¹ is 2 or 3, and more preferably 3.

When M is a palladium atom or a platinum atom, n¹ is 2.

E¹ is preferably carbon atoms.

The number of carbon atoms, not including carbon atoms of the substituents, in the aromatic hydrocarbon ring in the ring B is usually 6 to 60, preferably 6 to 30, and more preferably 6 to 18.

Examples of the aromatic hydrocarbon ring in the ring B include a benzene ring, a naphthalene ring, an indene ring, a fluorene ring, a phenanthrene ring, a dihydrophenanthrene ring, and a fused ring of such rings. The aromatic hydrocarbon ring in the ring B is preferably a benzene ring, a naphthalene ring, an indene ring, a fluorene ring, a phenanthrene ring, or a dihydrophenanthrene ring, more preferably a benzene ring, a fluorene ring, or a dihydrophenanthrene ring, and further preferably a benzene ring, and these rings may each have a substituent.

The number of carbon atoms, not including the carbon atoms of the substituents, in the aromatic heterocyclic ring in the ring B is usually 4 to 60, and preferably 4 to 20.

Examples of the aromatic heterocyclic ring in the ring B include a pyrrole ring, a diazole ring, a furan ring, a thiophene ring, a pyridine ring, a diazabenzene ring, an azanaphthalene ring, a diazanaphthalene ring, an indole ring, a benzodiazole ring, a benzofuran ring, a benzothiophene ring, a carbazole ring, a dibenzofuran ring, a dibenzothiophene ring, and a ring in which an aromatic ring is fused to such a ring. The aromatic heterocyclic ring in the ring B is preferably a pyrrole ring, a diazole ring, a furan ring, a thiophene ring, a pyridine ring, a diazabenzene ring, an azanaphthalene ring, a diazanaphthalene ring, an indole ring, a benzodiazole ring, a benzofuran ring, a benzothiophene ring, a carbazole ring, a dibenzofuran ring, or a dibenzothiophene ring, more preferably a pyridine ring, a diazabenzene ring, a carbazole ring, a dibenzofuran ring, or a dibenzothiophene ring, and further preferably a pyridine ring or a diazabenzene ring, and these rings may have a substituent.

The ring B is preferably a 5-membered or 6-membered aromatic hydrocarbon ring or a 5-membered or 6-membered aromatic heterocyclic ring, more preferably a benzene ring, a fluorene ring, a dihydrophenanthrene ring, a pyridine ring, a diazabenzene ring, a carbazole ring, a dibenzofuran ring, or a dibenzothiophene ring, further preferably a benzene ring, a pyridine ring, or a diazabenzene ring, and particularly preferably a benzene ring, because the luminance lifetime of the light emitting device according to the present embodiment is better, and these rings may have a substituent. When the ring B is a 6-membered aromatic heterocyclic ring, E¹ is preferably a carbon atom.

The substituent which the ring B may have is preferably an alkyl group, a cycloalkyl group, an alkoxy group, a cycloalkoxy group, an aryl group, an aryloxy group, a monovalent heterocyclic group, a substituted amino group, or a halogen atom, more preferably an alkyl group, a cycloalkyl group, an alkoxy group, a cycloalkoxy group, an aryl group, a monovalent heterocyclic group, a substituted amino group, or a fluorine atom, further preferably an alkyl group, a cycloalkyl group, an aryl group, a monovalent heterocyclic group, or a substituted amino group, particularly preferably an alkyl group, a cycloalkyl group, or an aryl group, and more particularly preferably an alkyl group, and these groups may further have a substituent.

The aryl group in the substituent which the ring B may have is preferably a phenyl group, a naphthyl group, an anthracenyl group, a phenanthrenyl group, a dihydrophenanthrenyl group, a fluorenyl group, or a pyrenyl group, more preferably a phenyl group, a naphthyl group, or a fluorenyl group, further preferably a phenyl group, and these groups may have a substituent.

The monovalent heterocyclic group in the substituent which the ring B may have is preferably a pyridyl group, a pyrimidinyl group, a triazinyl group, a quinolinyl group, an isoquinolinyl group, a dibenzofuranyl group, a dibenzothienyl group, a carbazolyl group, an azacarbazolyl group, a diazacarbazolyl group, a phenoxazinyl group, or a phenoxazinyl group; more preferably a pyridyl group, a pyrimidinyl group, a triazinyl group, a dibenzofuranyl group, a dibenzothienyl group, or a carbazolyl group; and further preferably a pyridyl group, a pyrimidinyl group, or a triazinyl group, and these groups may have a substituent.

The substituent which the amino group has in the substituted amino group in the substituent which the ring B may have is preferably an aryl group or a monovalent heterocyclic group, and more preferably an aryl group, and these groups may further have a substituent. Examples and preferable ranges of the aryl group in the substituent which the amino group has are the same as the examples and preferable ranges of the aryl group in the substituent which the ring B may have. The examples and preferable ranges of the monovalent heterocyclic group in the substituent which the amino group has are the same as the examples and preferable ranges of the monovalent heterocyclic group in the substituent which the ring B may have.

The aryl group, the monovalent heterocyclic group, and the substituted amino group among the substituents which the ring B may have are preferably groups represented by formula (D-A), (D-B), or (D-C), and more preferably groups represented by formula (D-A) or (D-C), because the luminance lifetime of the light emitting device according to the present embodiment is better.

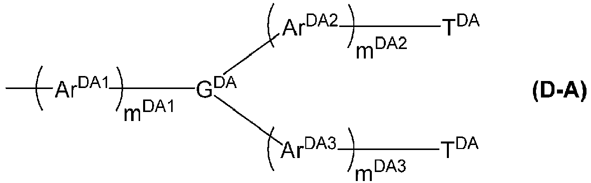

In the formula,
m^{DA1}, m^{DA2}, and m^{DA3} each independently represent an integer of 0 or more,
G^{DA} represents a nitrogen atom, an aromatic hydrocarbon group, or a heterocyclic group, and these groups may each have a substituent,
Ar^{DA1}, Ar^{DA2}, and Ar^{DA3} each independently represent an arylene group or a divalent heterocyclic group, and these groups may each have a substituent; and when there are a plurality of Ar^{DA1}, Ar^{DA2}, and Ar^{DA3}, they may be the same or different at each occurrence, and
T^{DA} represents an aryl group or a monovalent heterocyclic group, and these groups may each have a substituent; and the plurality of T^{DA} may be the same or different.

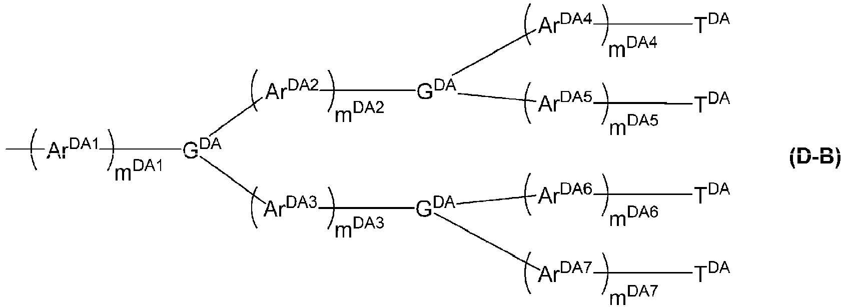

In the formula,
m^{DA1}, m^{DA2}, m^{DA3}, m^{DA4}, m^{DA5}, m^{DA6}, and m^{DA7} each independently represent an integer of 0 or more,
G^{DA} represents a nitrogen atom, an aromatic hydrocarbon group, or a heterocyclic group, and these groups may each have a substituent; the plurality of G^{DA} may be the same or different,
AR^{DA1}, Ar^{DA2}, Ar^{DA3}, Ar^{DA4}, Ar^{DA5}, Ar^{DA6}, and Ar^{DA7} each independently represent an arylene group or a divalent heterocyclic group, and these groups may each have a substituent; and when there are a plurality of Ar^{DA1}, Ar^{DA2}, Ar^{DA3}, Ar^{DA4}, Ar^{DA5}, Ar^{DA6}, and Ar^{DA7}, they may be the same or different at each occurrence, and
T^{DA} represents an aryl group or a monovalent heterocyclic group, and these groups may each have a substituent; the plurality of T^{DA} may be the same or different.

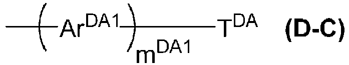

In the formula,
m^{DA1} represents an integer of 0 or more,
Ar^{DA1} represents an arylene group or a divalent heterocyclic group, and these groups may each have a substituent; and when there are a plurality of Ar^{DA1}, they may be the same or different, and
T^{DA} represents an aryl group or a monovalent heterocyclic group, and these groups may each have a substituent.
m^{DA1}, m^{DA2}, m^{DA3}, m^{DA4}, m^{DA5}, m^{DA6}, and m^{DA7} are generally an integer of 10 or less, preferably an integer of 5 or less, more preferably an integer of 2 or less, and still more preferably 0 or 1. It is preferable that m^{DA2}, m^{DA3}, m^{DA4}, m^{DA5}, m^{DA6}, and m^{DA7} are the same integer, and it is more preferable that m^{DA1}, m^{DA2}, m^{DA3}, m^{DA4}, m^{DA5}, m^{DA6}, and m^{DA7} are the same integer.
G^{DA} is preferably a group represented by formula (GDA-11) to formula (GDA-15), more preferably a group represented by formula (GDA-11) to formula (GDA-14), still more preferably a group represented by formula (GDA-11) or formula (GDA-14), and particularly preferably a group represented by formula (GDA-11).

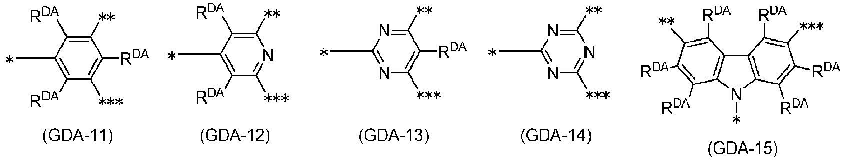

In the formulas,
^{∗} represents a bond with Ar^{DA1} in formula (D-A), Ar^{DA1} in formula (D-B), Ar^{DA2} in formula (D-B), or Ar^{DA3} in formula (D-B),
^{∗∗} represents a bond with Ar^{DA2} in formula (D-A), Ar^{DA2} in formula (D-B), Ar^{DA4} in formula (D-B), or Ar^{DA6} in formula (D-B),
^{∗∗∗} represents a bond with Ar^{DA3} in formula (D-A), Ar^{DA3} in formula (D-B), Ar^{DA5} in formula (D-B), or Ar^{DA7} in formula (D-B), and
R^{DA} represents a hydrogen atom, an alkyl group, a cycloalkyl group, an alkoxy group, a cycloalkoxy group, an aryl group, or a monovalent heterocyclic group, and these groups may each further have a substituent; when there are a plurality of R^{DA}, they may be the same or different.
R^{DA} is preferably a hydrogen atom, an alkyl group, a cycloalkyl group, an alkoxy group, or a cycloalkoxy group, more preferably a hydrogen atom, an alkyl group, or a cycloalkyl group, and these groups may each have a substituent.
AR^{DA1}, Ar^{DA2}, Ar^{DA3}, Ar^{DA4}, Ar^{DA5}, Ar^{DA6}, and Ar^{DA7} are preferably a phenylene group, a fluorenediyl group, or a carbazolediyl group, more preferably a group represented by formula (A-1) to formula (A-3), formula (A-8), formula (A-9), formula (AA-10), formula (AA-11), formula (AA-33), or formula (AA-34), and still more preferably a group represented by formula (ArDA-1) to formula (ArDA-5), particularly preferably a group represented by formula (ArDA-1) to formula (ArDA-3), and especially preferably a group represented by formula (ArDA-1).

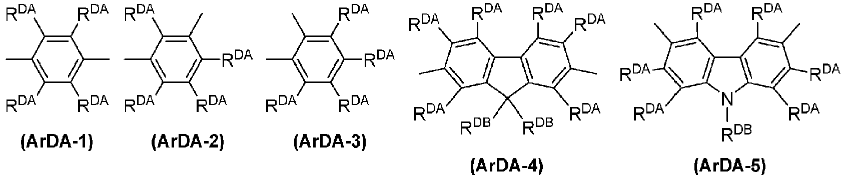

In the formulas, R^{DA} represents the same meaning as described above,
R^{DB} represents a hydrogen atom, an alkyl group, a cycloalkyl group, an aryl group, or a monovalent heterocyclic group, and these groups may each have a substituent; and when there are a plurality of R^{DB}, they may be the same or different.
R^{DB} is preferably an alkyl group, a cycloalkyl group, an aryl group, or a monovalent heterocyclic group, more preferably an aryl group or a monovalent heterocyclic group, and still more preferably an aryl group, and these groups may each have a substituent.
T^{DA} is preferably a group represented by formula (TDA-1) to formula (TDA-3), more preferably a group represented by formula (TDA-1).

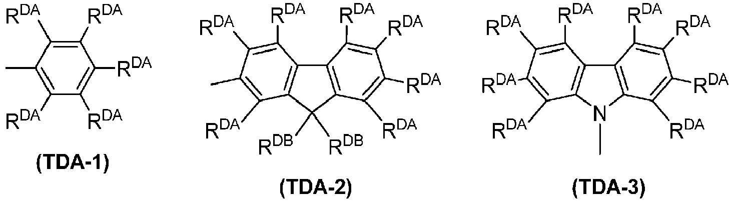

In the formulas, R^{DA} and R^{DB} represent the same meanings as described above.

The group represented by formula (D-A) is preferably a group represented by any of formula (D-A1) to formula (D-A4), more preferably a group represented by formula (D-A1), formula (D-A3), or formula (D-A4), further preferably a group represented by formula (D-A1) or formula (D-A4), and particularly preferably a group represented by formula (D-A1).

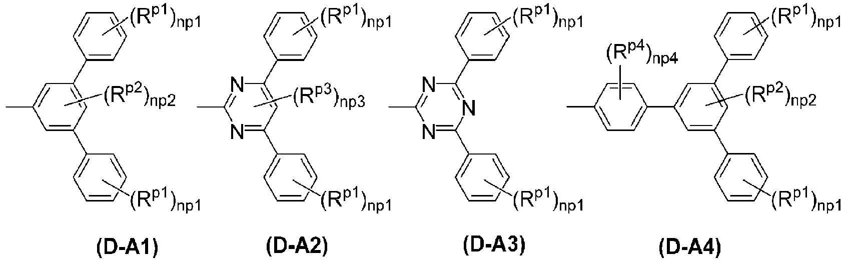

In the formulas,
R^{p1}, R^{p2}, R^{p3}, and R^{p4} each independently represent an alkyl group, a cycloalkyl group, an alkoxy group, a cycloalkoxy group, or a halogen atom; when there are a plurality of R^{p1}, R^{p2}, and R^{p4}, they may be the same or different at each occurrence, and
np1 represents an integer of 0 to 5, np2 represents an integer of 0 to 3, np3 represents 0 or 1, and np4 represents an integer of 0 to 4; the plurality of np1 may be the same or different.

The group represented by formula (D-B) is preferably a group represented by any of formula (D-B1) to formula (D-B3), more preferably a group represented by formula (D-B1) or formula (D-B3), and further preferably a group represented by formula (D-B1).

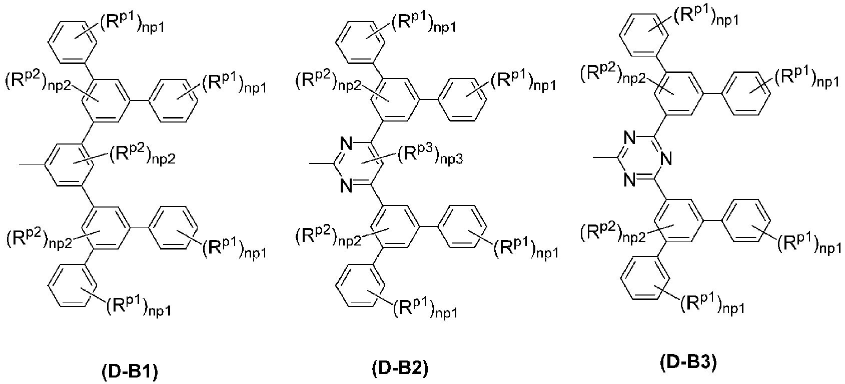

In the formulas,
R^{p1}, R^{p2}, and R^{p3} each independently represent an alkyl group, a cycloalkyl group, an alkoxy group, a cycloalkoxy group, or a halogen atom; when there are a plurality of R^{p1} and R^{p2}, they may be the same or different at each occurrence, and
np1 represents an integer of 0 to 5, np2 represents an integer of 0 to 3, and np3 represents 0 or 1; when there are a plurality of np1 and np2, they may be the same or different at each occurrence.

The group represented by formula (D-C) is preferably a group represented by formula (D-C1) to formula (D-C4), more preferably a group represented by formula (D-C1) to formula (D-C3), further preferably a group represented by formula (D-C1) or formula (D-C2), and particularly preferably a group represented by formula (D-C1).

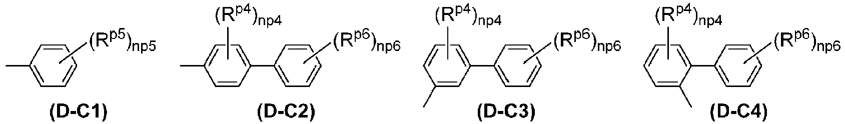

In the formulas, R^{p4}, R^{p5}, and R^{p6} each independently represent an alkyl group, a cycloalkyl group, an alkoxy group, a cycloalkoxy group, or a halogen atom; when there are a plurality of R^{p4}, R^{p5}, and R^{p6}, they may be the same or different at each occurrence, and
np4 represents an integer of 0 to 4, np5 represents an integer of 0 to 5, and np6 represents an integer of 0 to 5.
np1 is preferably 0 or 1, more preferably 1. np2 is preferably 0 or 1, and more preferably 0. np3 is preferably 0. np4 is preferably an integer of 0 to 2. np 5 is preferably an integer of 1 to 3. np6 is preferably an integer of 0 to 2.
R^{p1}, R^{p2}, R^{p3}, R^{p4}, R^{p5}, and R^{p6} are preferably an alkyl group or a cycloalkyl group, more preferably a methyl group, an ethyl group, an isopropyl group, a tert-butyl group, a hexyl group, a 2-ethylhexyl group, a cyclohexyl group, or a tert-octyl group, and still more preferably a methyl group, an ethyl group, an isopropyl group, a tert-butyl group, a hexyl group, a 2-ethylhexyl group, or a tert-octyl group.

Examples of the group represented by formula (D-A) include groups represented by formula (D-A-1) to formula (D-A-12).

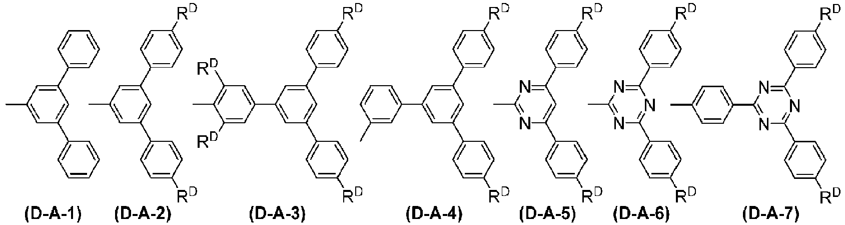

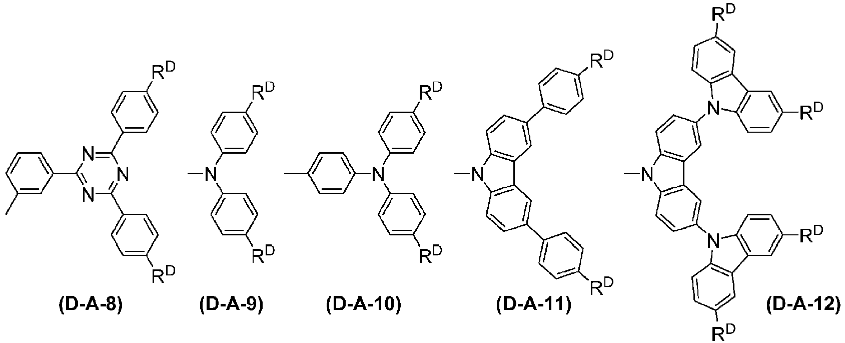

In the formulas,
R^{D} represents a methyl group, an ethyl group, an isopropyl group, a tert-butyl group, a hexyl group, a 2-ethylhexyl group, a tert-octyl group, a cyclohexyl group, a methoxy group, a 2-ethylhexyloxy group, or a cyclohexyloxy group; when there are a plurality of R^{D}, they may be the same or different.

Examples of the group represented by formula (D-B) include groups represented by formula (D-B-1) to formula (D-B-4).

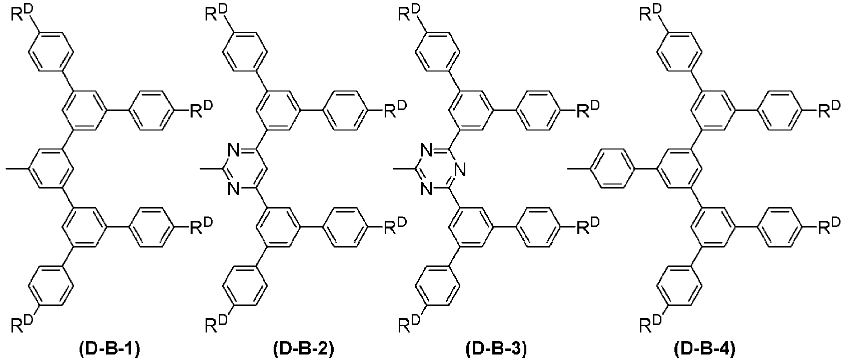

In the formulas,
R^{D} represents the same meaning as described above.

Examples of the group represented by formula (D-C) include groups represented by formula (D-C-1) to formula (D-C-13).

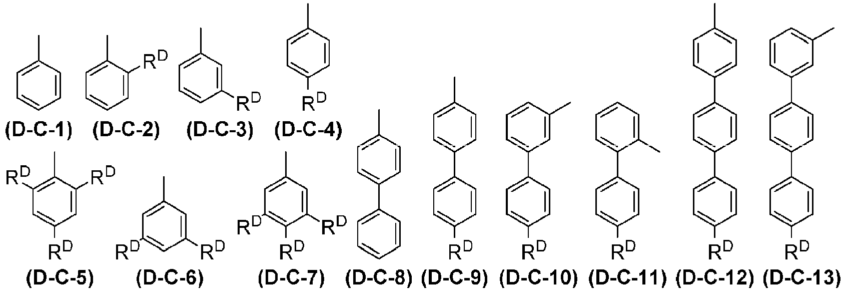

In the formulas, R^{D} represents the same meaning as described above.
R^{D} is preferably a methyl group, an ethyl group, an isopropyl group, a tert-butyl group, a hexyl group, a 2-ethylhexyl group, or a tert-octyl group.

When there are a plurality of substituents which the ring B may have, they may be bonded to each other to form a ring together with the atoms to which they are bonded, but because the maximum peak wavelength of the emission spectrum of the metal complex represented by formula (1) becomes a short wavelength, it is preferable not to form a ring.

The substituent which the substituent which the ring B may have may further have is preferably an alkyl group, a cycloalkyl group, an alkoxy group, a cycloalkoxy group, an aryl group, an aryloxy group, a monovalent heterocyclic group, a substituted amino group, or a halogen atom; more preferably an alkyl group, a cycloalkyl group, an alkoxy group, a cycloalkoxy group, an aryl group, a monovalent heterocyclic group, a substituted amino group, or a fluorine atom; further preferably an alkyl group, a cycloalkyl group, or an aryl group; and particularly preferably an alkyl group, and these groups may further have a substituent.

The examples and preferable ranges of the aryl group, the monovalent heterocyclic group, or the substituted amino group in the substituent which the substituent which the ring B may have may further have are the same as the examples and preferable ranges of the aryl group, the monovalent heterocyclic group, or the substituted amino group in the substituent which the ring B may have.

Z^{1A} is preferably a group represented by = N-.

R^{Z1A} is preferably a hydrogen atom, an alkyl group, a cycloalkyl group, an alkoxy group, a cycloalkoxy group, an aryl group, a monovalent heterocyclic group, a substituted amino group, or a fluorine atom; more preferably a hydrogen atom, an alkyl group, a cycloalkyl group, an aryl group, or a monovalent heterocyclic group; further preferably a hydrogen atom, an alkyl group, or a cycloalkyl group; and particularly preferably a hydrogen atom, and these groups may further have a substituent.

The examples and preferable ranges of the aryl group, the monovalent heterocyclic group, or the substituted amino group in R^{Z1A} are the same as the examples and preferable ranges of the aryl group, the monovalent heterocyclic group, or the substituted amino group in the substituent which the ring B may have.

The examples and preferable ranges of the substituent which Z^{1A} may have are the same as the examples and preferable ranges of the substituent which the substituent which the ring B may have may further have.

R¹ is a tertiary alkyl group having n^{R1} carbon atoms and the group may have a substituent. n^{R1} represents the number of carbon atoms in the alkyl group not including the carbon atoms of the substituent. Examples of alkyl groups in general include linear alkyl groups such as a methyl group, an ethyl group, a propyl group, a butyl group, a pentyl group, a hexyl group, a heptyl group, an octyl group, a decyl group, and a dodecyl group; and a branched alkyl group such as an isopropyl group, a sec-butyl group, an isobutyl group, a tert-butyl group, an isopentyl group, a neopentyl group, a tert-pentyl group, a 1,1-dimethylbutyl group, a 1-ethylbutyl group, a 2-ethylbutyl group, a 1,1-dimethyl pentyl group, a 1,1-diethylpropyl group, a 1,2-dimethylpentyl group, a 1,1-dimethylhexyl group, a 1-ethyl-1-methylpentyl group, a 1,1,3,3-tetramethylbutyl group, a 1,2-dimethylhexyl group, a 1-propylpentyl group, a 2-ethylhexyl group, a 1,1-dimethylheptyl group, a 1,1-dipropylbutyl group, a 1-butylhexyl group, a 1-propylheptyl group, a 1,1,3,7-tetramethyloctyl group, and a 1,1,2-triethyloctyl group.

An alkyl group in general may be a primary alkyl group such as a methyl group, an ethyl group, a propyl group, a butyl group, isobutyl group, a pentyl group, an isopentyl group, a neopentyl group, a 2-ethylbutyl group, a hexyl group, a heptyl group, an octyl group, a 2-ethylhexyl group, a decyl group, and a dodecyl group; or a secondary alkyl group such as an isopropyl group, a sec-butyl group, a 1-ethylbutyl group, a 1,2-dimethylpentyl group, a 1,2-dimethylhexyl group, a 1-propylpentyl group, a 1-butylhexyl group, and a 1-propylheptyl group. In the present invention, the alkyl group in R¹ is a tertiary alkyl group, such as a tert-butyl group, a tert-pentyl group, a 1,1-dimethylbutyl group, a 1,1-dimethylpentyl group, a 1,1-diethylpropyl group, a 1,1-dimethylhexyl group, a 1-ethyl-1-methylpentyl group, a 1,1,3,3-tetramethylbutyl group, a 1,1-dimethylheptyl group, a 1,1-dipropylbutyl group, a 1,1,3,7-tetramethyloctyl group, and a 1,1,2-triethyloctyl group.

The substituent which R¹ may have is preferably a cycloalkyl group, an alkoxy group, a cycloalkoxy group, an aryl group, an aryloxy group, a monovalent heterocyclic group, a substituted amino group, or a halogen atom; more preferably a cycloalkyl group, an alkoxy group, a cycloalkoxy group, an aryl group, a monovalent heterocyclic group, a substituted amino group, or a fluorine atom; further preferably a cycloalkyl group or an aryl group, and these groups may further have a substituent.

The examples and preferable ranges of the aryl group, the monovalent heterocyclic group, or the substituted amino group in the substituent which R¹ may have are the same as the examples and preferable ranges of the aryl group, the monovalent heterocyclic group, or the substituted amino group in the substituent which the ring B may have.

R¹ is a a tertiary alkyl group having n^{R1} carbon atoms, and particularly preferably these groups do not have a substituent, because the luminance lifetime of the light emitting device according to the present embodiment is better.

n^{R1} is 4 or more, and particularly preferably 5 or more. Moreover, n^{R1} is preferably 14 or less, more preferably 12 or less, further preferably 10 or less, particularly preferably 8 or less, and more particularly preferably 7 or less.

### [Group represented by (formula Ar-1A)]

The examples and preferable ranges of the aromatic hydrocarbon ring in the ring A are the same as the examples and preferable ranges of the aromatic hydrocarbon ring in the ring B. The examples and preferable ranges of the aromatic heterocyclic ring in the ring A are the same as the examples and preferable ranges of the aromatic hydrocarbon ring in the ring B.

The ring A is preferably a 5-membered or 6-membered aromatic hydrocarbon ring or a 5-membered or 6-membered aromatic heterocyclic ring, more preferably a benzene ring, a fluorene ring, a dihydrophenanthrene ring, a pyridine ring, a diazabenzene ring, a carbazole ring, a dibenzofuran ring, or a dibenzothiophene ring, further preferably a benzene ring, a pyridine ring, or a diazabenzene ring, particularly preferably a benzene ring, and these rings may have a substituent, because the luminance lifetime of the light emitting device according to the present embodiment is better.

The substituent which the ring A may have is preferably an alkyl group, a cycloalkyl group, an alkoxy group, a cycloalkoxy group, an aryl group, an aryloxy group, a monovalent heterocyclic group, a substituted amino group, or a halogen atom; more preferably an alkyl group, a cycloalkyl group, an alkoxy group, a cycloalkoxy group, an aryl group, a monovalent heterocyclic group, a substituted amino group, or a fluorine atom ; further preferably an alkyl group, a cycloalkyl group, an aryl group, a monovalent heterocyclic group, or a substituted amino group; particularly preferably an alkyl group, a cycloalkyl group, or an aryl group; and more particularly preferably an aryl group, and these groups may further have a substituent.

The examples and preferable ranges of the aryl group, the monovalent heterocyclic group, or the substituted amino group in the substituent which the ring A may have are the same as the examples and preferable ranges of the aryl group, the monovalent heterocyclic group, or the substituted amino group in the substituent which the ring B may have.

When there are a plurality of substituents which the ring A may have, they may be bonded to each other to form a ring together with atoms to which they are bonded, but, because the maximum peak wavelength of the emission spectrum of the metal complex represented by formula (1) becomes a short wavelength, it is preferable not to form a ring.

The examples and preferable ranges of the substituent which the substituent which the ring A may have may further have are the same as the examples and preferable ranges of the substituent which the substituent which the ring B may have may further have.

R² is an alkyl group having n^{R2} carbon atoms and the group may have a substituent. The examples of the alkyl group having n^{R2} carbon atoms in R² include the same groups as the examples of the alkyl group having n^{R1} carbon atoms in R¹. n^{R2} represents the number of carbon atoms in the alkyl group, not including the carbon atoms of the substituent.

The examples and preferable ranges of the substituent which R² may have are the same as the examples and preferable ranges of the substituent that R¹ may have.

R² is preferably a primary or secondary alkyl group having n^{R2} carbon atoms and more preferably a secondary alkyl group having n^{R2} carbon atoms and further preferably these groups do not have a substituent, because synthesis is easier.

n^{R2} is preferably 1 or more and 10 or less, more preferably 1 or more and 7 or less, further preferably 1 or more and 5 or less, particularly preferably 1 or more and 3 or less, and more particularly preferably 3, because synthesis is easier.

The sum of n^{R1} and n^{R2} (n^{R1} + n^{R2}) is preferably 7 or more and 20 or less, more preferably 7 or more and 15 or less, further preferably 7 or more and 12 or less, and particularly preferably 8 or more and 10 or less.

R³ is preferably a cycloalkyl group, an alkoxy group, a cycloalkoxy group, an aryl group, a monovalent heterocyclic group, a substituted amino group, a fluorine atom, or an alkyl group having n^{R3} carbon atoms; more preferably a cycloalkyl group, an aryl group, a monovalent heterocyclic group, a substituted amino group, or an alkyl group having n^{R3} carbon atoms; further preferably a cycloalkyl group, an aryl group, or an alkyl group having n^{R3} carbon atoms; and more preferably an alkyl group having n^{R3} carbon atoms; and these groups may further have a substituent.

The examples and preferable ranges of the aryl group, the monovalent heterocyclic group, or the substituted amino group in R³ are the same as the examples and preferable ranges of the aryl group, the monovalent heterocyclic group, or the substituted amino group in the substituent which the ring B may have.

The examples of the alkyl group having n^{R3} carbon atoms in R³ include the same groups as the examples of the alkyl group having n^{R1} carbon atoms in R¹. n^{R3} represents the number of carbon atoms in the alkyl group, not including the substituent.

The alkyl group having n^{R3} carbon atoms in R³ is preferably a primary or secondary alkyl group having n^{R3} carbon atoms and more preferably a secondary alkyl group having n^{R3} carbon atoms and further preferably these groups do not have a substituent, because synthesis is easier.

When R³ is other than the alkyl group having n^{R3} carbon atoms, the examples and preferable ranges of the substituent which R³ may have are the same as the examples and preferable ranges of the substituent which the substituent which the ring B may have may further have.

When R³ is the alkyl group having n^{R3} carbon atoms, the examples and preferable ranges of the substituent which R³ may have are the same as the examples and preferable ranges of the substituent that R¹ may have.

n^{R3} is preferably 1 or more and 10 or less, more preferably 1 or more and 7 or less, further preferably 1 or more and 5 or less, and particularly preferably 1 or more and 3 or less, because synthesis is easier.

When R³ is the alkyl group having n^{R3} carbon atoms, n^{R3} is usually n^{R2} or less (n^{R3} <= n^{R2}) and preferably n^{R2} and n^{R3} are the same integer, because synthesis is easier.

R² and R³ are preferably the same.

The group represented by formula (Ar-1A) is preferably a group represented by formula (Ar-2A), because the luminance lifetime of the light emitting device according to the present embodiment is better.

E^{1A}, E^{2A}, and E^{3A} are preferably carbon atoms.

R^{1A}, R^{2A}, and R^{3A} are each preferably a hydrogen atom, an alkyl group, a cycloalkyl group, an alkoxy group, a cycloalkoxy group, an aryl group, a monovalent heterocyclic group, a substituted amino group, or a fluorine atom; more preferably a hydrogen atom, an alkyl group, a cycloalkyl group, an aryl group, a monovalent heterocyclic group, or a substituted amino group, and further preferably a hydrogen atom, an alkyl group, a cycloalkyl group, or an aryl group, and these groups may have a substituent.

R^{1A} and R^{3A} are each particularly preferably a hydrogen atom, an alkyl group, or an aryl group, and more particularly preferably a hydrogen atom, and these groups may have a substituent.

R^{2A} is particularly preferably a hydrogen atom, an alkyl group, or an aryl group, more particularly preferably an alkyl group or an aryl group, and even more preferably an aryl group, and these groups may have a substituent.

The examples and preferable ranges of the aryl group, the monovalent heterocyclic group, or the substituted amino group in R^{1A}, R^{2A}, and R^{3A} are the same as the examples and preferable ranges of the aryl group, the monovalent heterocyclic group, or the substituted amino group in the substituent which the ring B may have.

Examples and preferable ranges of the substituent which R^{1A}, R^{2A}, and R^{3A} may have are the same as the examples and preferable ranges of the substituent which the substituent which the ring B may have may further have.

R^{1A} and R^{2A} as well as R^{2A} and R^{3A} may be bonded to each other to form a ring together with the atoms to which they are bonded, but it is preferable not to form a ring.

When the ring A¹ is a pyridine ring, the pyridine ring is preferably a pyridine ring in which E^{1A} is a nitrogen atom.

When the ring A¹ is a diazabenzene ring, the diazabenzene ring is preferably a pyrimidine ring in which E^{1A} and E^{3A} are nitrogen atoms.

The ring A¹ is preferably a benzene ring.

### [Anionic Bidentate Ligand]

Examples of the anionic bidentate ligand represented by A¹-G¹-A² include ligands represented by the following formulas. The anionic bidentate ligand represented by A¹-G¹-A² is different from the ligand whose number is defined by the suffix n¹.

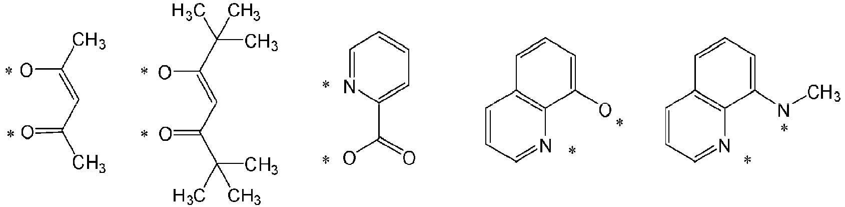

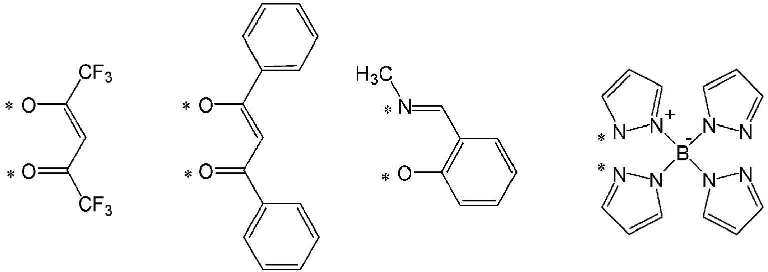

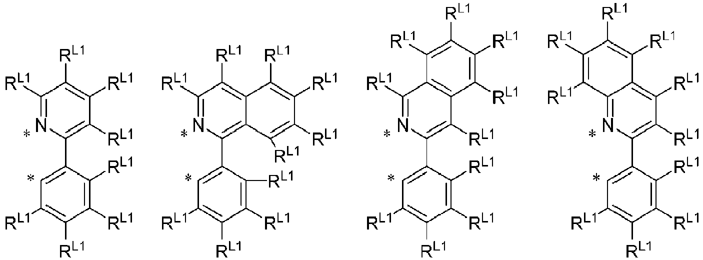

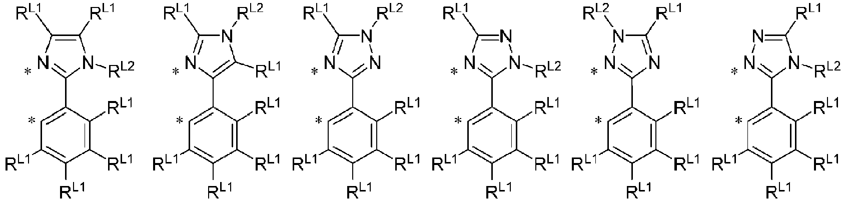

In the formulas,
^{∗} represents a site which binds to M,
R^{L1} represents a hydrogen atom, an alkyl group, a cycloalkyl group, an aryl group, a monovalent heterocyclic group, or a halogen atom, and these groups may have a substituent. When there are a plurality of R^{L1}, they may be the same or different, and
R^{L2} represents an alkyl group, a cycloalkyl group, an aryl group, a monovalent heterocyclic group, or a halogen atom, and these groups may have a substituent.
R^{L1} is preferably a hydrogen atom, an alkyl group, a cycloalkyl group, an aryl group, or a fluorine atom, more preferably a hydrogen atom or an alkyl group, and further preferably a hydrogen atom, and these groups may have a substituent.
R^{L2} is preferably an alkyl group, a cycloalkyl group, an aryl group, or a monovalent heterocyclic group and more preferably an alkyl group or a cycloalkyl group, and these groups may have a substituent.

### <Metal complex represented by formula (1-1)>

The metal complex represented by formula (1) is preferably a metal complex represented by formula (1-1), because the luminance lifetime of the light emitting device according to the present embodiment is better.

E^{1B}, E^{2B}, E^{3B}, and E^{4B} are preferably carbon atoms.

R^{1B}, R^{2B}, R^{3B}, and R^{4B} are each preferably a hydrogen atom, an alkyl group, a cycloalkyl group, an alkoxy group, a cycloalkoxy group, an aryl group, a monovalent heterocyclic group, a substituted amino group, or a fluorine atom; more preferably a hydrogen atom, an alkyl group, a cycloalkyl group, an aryl group, a monovalent heterocyclic group, or a substituted amino group, and further preferably a hydrogen atom, an alkyl group, a cycloalkyl group, or an aryl group, and these groups may further have a substituent.

R^{1B}, R^{3B}, and R^{4B} are each more preferably a hydrogen atom or an alkyl group, and particularly preferably a hydrogen atom, and these groups may further have a substituent.

R^{2B} is particularly preferably a hydrogen atom, an alkyl group, or an aryl group, and particularly preferably a hydrogen atom or an alkyl group, and more particularly preferably an alkyl group, and these groups may further have a substituent.

The examples and preferable ranges of the aryl group, the monovalent heterocyclic group, or the substituted amino group in R^{1B}, R^{2B}, R^{3B}, and R^{4B} are the same as the examples and preferable ranges of the aryl group, the monovalent heterocyclic group, or the substituted amino group in the substituent which the ring B may have.

Examples and preferable ranges of the substituent which R^{1B}, R^{2B}, R^{3B}, and R^{4B} may have are the same as the examples and preferable ranges of the substituent which the substituent which the ring B may have may further have.

When the ring B¹ is a pyridine ring, the ring B¹ is preferably a pyridine ring in which E^{1B} is a nitrogen atom, a pyridine ring in which E^{2B} is a nitrogen atom, or a pyridine ring in which E^{3B} is a nitrogen atom, and more preferably a pyridine ring in which E^{2B} is a nitrogen atom.

When the ring B¹ is a diazabenzene ring, the ring B¹ is preferably a pyrimidine ring in which E^{2B} and E^{4B} are nitrogen atoms or a pyrimidine ring in which E^{1B} and E^{3B} are nitrogen atoms, and more preferably a pyrimidine ring in which E^{2B} and E^{4B} are nitrogen atoms.

The ring B¹ is preferably a benzene ring.

The metal complex represented by formula (1-1) is preferably a metal complex represented by formula (1-2), because the luminance lifetime of the light emitting device according to the present embodiment is better.

Examples of the metal complex represented by formula (1) include the metal complexes represented by the following formulas.

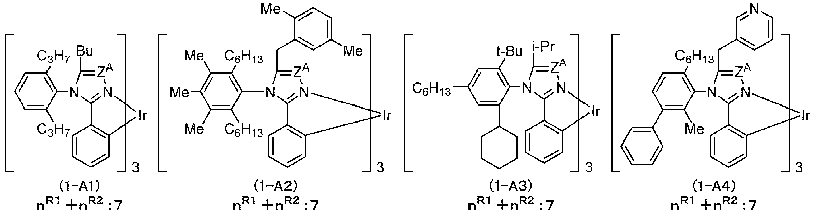

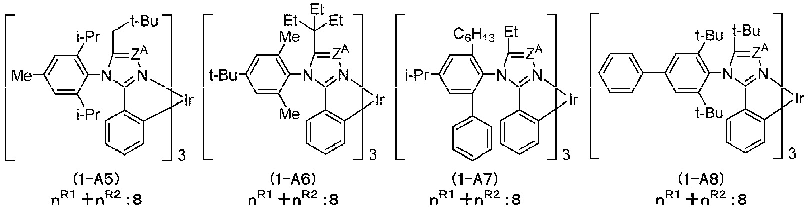

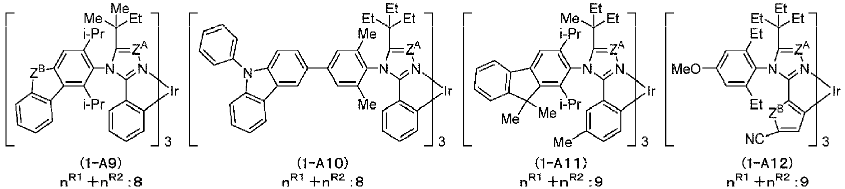

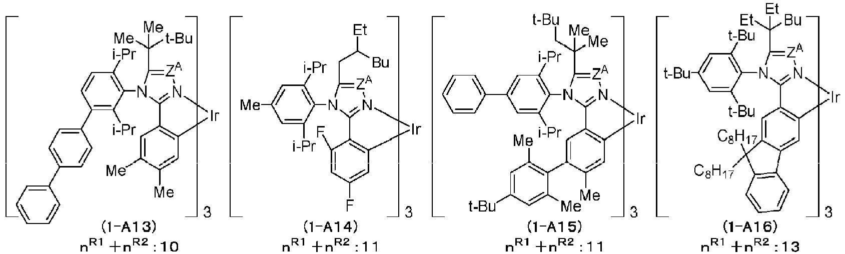

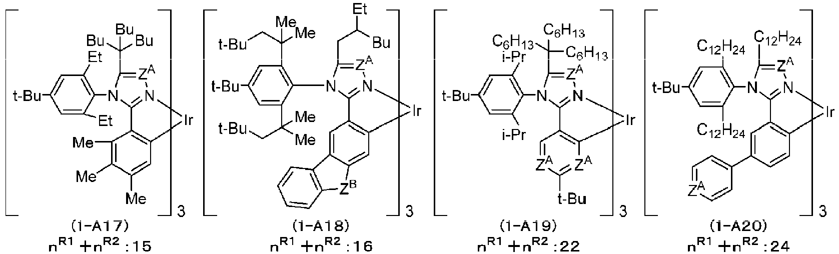

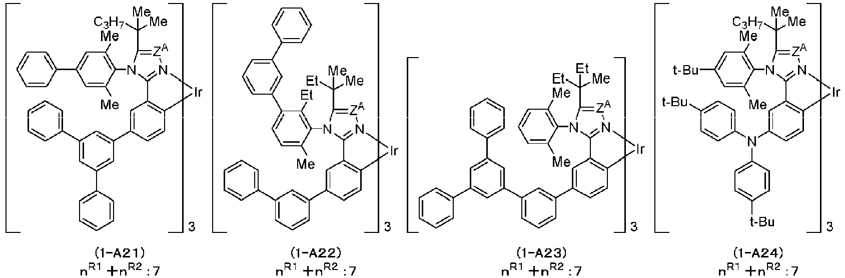

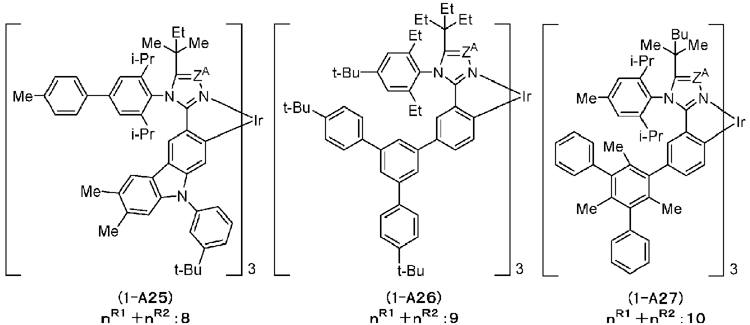

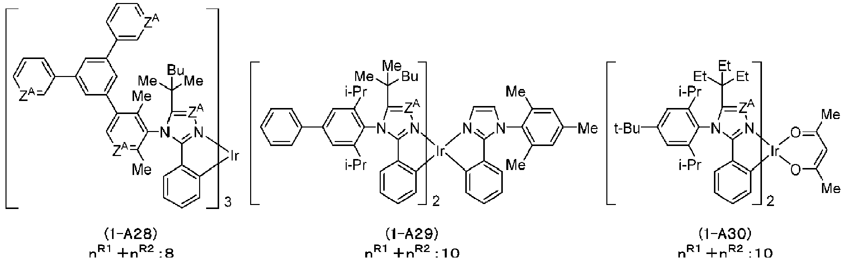

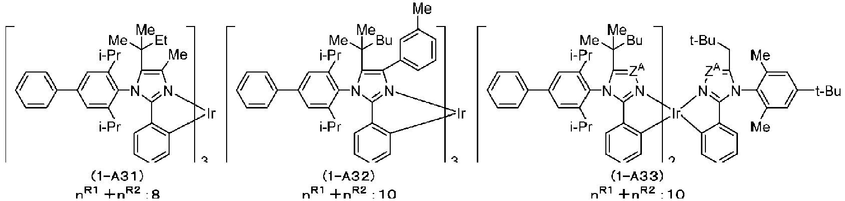

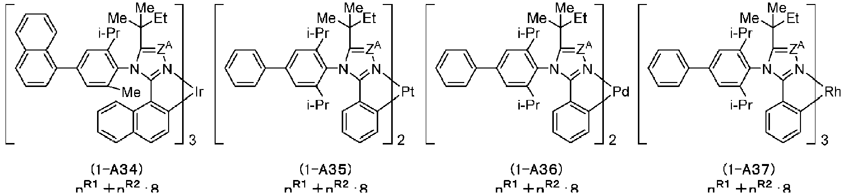

Metal complexes 1-A1 to 1-A4, 1-A7, 1-A14, 1-A18 and 1-A20 do not form part of the claimed invention. In the formulas,
Z^{A} represents a group represented by -CH= or a group represented by -N=; when there are a plurality of Z^{A}, they may be the same or different; and Z^{A} is preferably a group represented by -N=, and
Z^{B} represents a group represented by -O- or a group represented by -S-.

### <Method for Producing Metal Complex Represented by Formula (1)>

The metal complex represented by formula (1) can be produced by, for example, a method in which a compound serving as a ligand is reacted with a metal compound. Optionally, a functional group conversion reaction of the ligand of the metal complex may be carried out.

The metal complex represented by formula (1) can be produced by, for example, a step A of reacting a compound represented by formula (M-1) with a metal compound or a hydrate thereof, and a step B of reacting the compound obtained in step A (hereinafter also referred to as "metal complex intermediary (1)") with a compound represented by formula (M-1) or a precursor of a ligand represented by A¹-G¹-A².

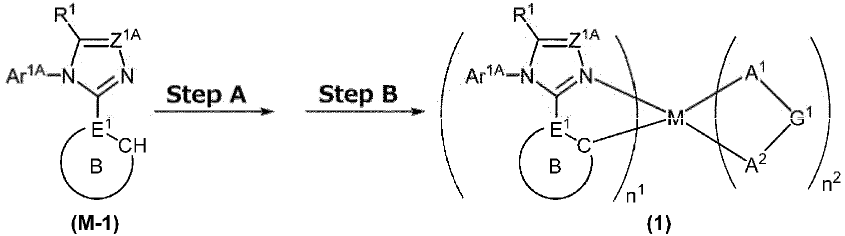

In the formulas, M, n¹, n², E¹, ring B, Z^{1A}, R¹, Ar^{1A}, and A¹-G¹-A² represent the same meanings as described above.

In step A, examples of the metal compound include iridium compounds such as iridium chloride, tris(acetylacetonato)iridium(III), chloro(cyclooctadiene)iridium(I) dimer, and iridium(III) acetate; platinum compounds such as potassium chloroplatinate; palladium compounds such as palladium chloride and palladium acetate; and rhodium compounds such as rhodium chloride. Examples of hydrates of metal compounds include iridium chloride trihydrate and rhodium chloride trihydrate.

Examples of the metal complex intermediary (1) include a metal complex represented by formula (M-2).

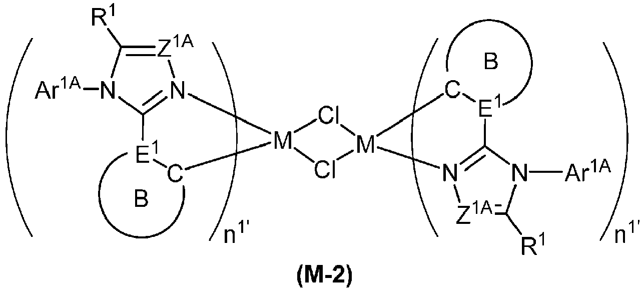

In the formula, M, E1, ring B, Z^{1A}, R¹, Ar^{1A}, and A¹-G¹-A² represent the same meanings as described above, and
n¹' represents 1 or 2; when M is a rhodium atom or an iridium atom, n¹' is 2; and when M is a palladium atom or a platinum atom, n¹' is 1.

In the step A, the amount of the compound represented by formula (M-1) is usually 2 to 20 moles with respect to 1 mole of the metal compound or hydrate.

In step B, the amount of the compound represented by formula (M-1) or the precursor of the ligand represented by A¹-G¹-A² is usually 1 to 100 moles with respect to 1 mole of the metal complex intermediate (1).

In step B, the reaction is preferably carried out in the presence of a silver compound such as silver trifluoromethanesulfonate. When a silver compound is used, its amount is usually 2 to 20 moles relative to 1 mole of the metal complex intermediate (1).

Steps A and B are usually carried out in a solvent. Examples of the solvent include alcohol solvents such as methanol, ethanol, propanol, ethylene glycol, glycerin, 2-methoxyethanol, and 2-ethoxyethanol; ether solvents such as diethyl ether, tetrahydrofuran (THF), dioxane, cyclopentyl methyl ether, and diglyme; halogen type solvents such as methylene chloride and chloroform; nitrile type solvents such as acetonitrile and benzonitrile; hydrocarbon solvents such as hexane, decalin, toluene, xylene, and mesitylene; amide solvents such as N,N-dimethylformamide, N,N-dimethylacetamide; acetone, dimethylsulfoxide, water, and the like.

In steps A and B, the reaction time is usually 30 minutes to 200 hours, and the reaction temperature is usually between the melting point and the boiling point of the solvent present in the reaction system.

The compounds, catalysts, and solvents used in the reaction described in <Method for Producing Metal Complex Represented by Formula (1)> may each be used singly or in combinations of two or more.

### [Host Material]

The light emitting layer is preferably a layer comprising a metal complex represented by formula (1) and a host material having at least one function of hole injectability, hole transportability, electronic injectability, and electronic transportability, because the luminance lifetime of the light emitting device according to the present embodiment is better. The light emitting layer may contain one host material alone or 2 or more host materials.

When the light emitting layer is a layer containing a metal complex represented by formula (1) and a host material, the content of the metal complex represented by formula (1) is usually 0.1 to 50 parts by mass, preferably 1 to 45 parts by mass, more preferably 5 to 40 parts by mass, and further preferably 10 to 35 parts by mass, based on a total of the metal complex and the host material of 100 parts by mass.

When the light emitting layer is a layer containing a metal complex represented by formula (1) and a host material, the lowest excited triplet state (T₁) of the host material is preferably higher than the energy level of T₁ of the metal complex represented by formula (1) contained in the light emitting layer, because the luminance lifetime of the light emitting device according to the present embodiment is better.

It is preferable that the host material exhibits solubility in solvents capable of dissolving the metal complex represented by formula (1) contained in the light emitting layer, because this enables the light emitting device according to the present embodiment to be produced by a solution coating process.

The host material is classified into a low molecular weight compound (low molecular weight host) and a polymer compound (polymer host). The light emitting layer may comprise either of the host materials, but preferably comprises a low molecular weight host.

### [Low Molecular Weight Host]

Low molecular weight compounds (hereinafter referred to as "low molecular weight host") preferable as the host material will now be described.

The low molecular weight host is preferably a compound represented by formula (H-1).

Ar^{H1} and Ar^{H2} are preferably a phenyl group, a fluorenyl group, a spirobifluorenyl group, a pyridyl group, a pyrimidinyl group, a triazinyl group, a quinolinyl group, an isoquinolinyl group, a thienyl group, a benzothienyl group, a dibenzothienyl group, a furyl group, a benzofuryl group, a dibenzofuryl group, a pyrrolyl group, an indolyl group, an azaindolyl group, a carbazolyl group, an azacarbazolyl group, a diazacarbazolyl group, a phenoxazinyl group, or a phenothiazinyl group, more preferably a phenyl group, a fluorenyl group, a spirobifluorenyl group, a pyridyl group, a pyrimidinyl group, a triazinyl group, a dibenzothienyl group, a dibenzofuryl group, a carbazolyl group, or an azacarbazolyl group, still more preferably a fluorenyl group, a spirobifluorenyl group, a dibenzothienyl group, a dibenzofuryl group, or a carbazolyl group, particularly preferably a group represented by formula (TDA-3), and these groups may each have a substituent.

The optional substituent of Ar^{H1} and Ar^{H2} is preferably a halogen atom, an alkyl group, a cycloalkyl group, an alkoxy group, a cycloalkoxy group, an aryl group, or a monovalent heterocyclic group, more preferably an alkyl group, a cycloalkoxy group, an alkoxy group, or a cycloalkoxy group, and still more preferably an alkyl group or a cycloalkoxy group, and these groups may each further have a substituent.

n^{H1} is preferably 1. n^{H2} is preferably 0.
n^{H3} is usually an integer of 0 to 10, preferably an integer of 0 to 5, more preferably an integer of 1 to 3, and particularly preferably 1.
n^{H11} is preferably an integer of 1 or more and 5 or less, more preferably an integer of 1 or more and 3 or less, and still more preferably 1.
R^{H11} is preferably a hydrogen atom, an alkyl group, a cycloalkyl group, an aryl group, or a monovalent heterocyclic group, more preferably a hydrogen atom, an alkyl group, or a cycloalkyl group, and still more preferably a hydrogen atom or an alkyl group, and these groups may each have a substituent.
L^{H1} is preferably an arylene group or a divalent heterocyclic group.
L^{H1} is preferably a group represented by formula (A-1) to formula (A-3), formula (A-8) to formula (A-10), formula (AA-1) to formula (AA-6), formula (AA-10) to formula (AA-21), or formula (A-24) to formula (AA-34), more preferably a group represented by formula (A-1), formula (A-2), formula (A-8), formula (A-9), formula (AA-1) to formula (AA-4), formula (AA-10) to formula (AA-15), formula (A-33), or formula (AA-34), still more preferably a group represented by formula (A-1), formula (A-2), formula (A-8), formula (AA-2), formula (AA-4), formula (AA-10), formula (AA-12), formula (AA-14), or formula (AA-33), particularly preferably a group represented by formula (A-8), formula (AA-10), formula (AA-12), or formula (AA-14), and especially preferably a group represented by formula (AA-14).

The optional substituent of L^{H1} is preferably a halogen atom, an alkyl group, a cycloalkyl group, an alkoxy group, a cycloalkoxy group, an aryl group, or a monovalent heterocyclic group, more preferably an alkyl group, an alkoxy group, an aryl group, or a monovalent heterocyclic group, and still more preferably an alkyl group, an aryl group, or a monovalent heterocyclic group, particularly preferably a monovalent heterocyclic group, and these groups may each further have a substituent.

L^{H21} is preferably a single bond or an arylene group, and more preferably a single bond, and the arylene group may have a substituent.

The definition and examples of the arylene group or divalent heterocyclic group represented by L^{H21} are the same as the definition and examples of the arylene group or divalent heterocyclic group represented by L^{H1}.

R^{H21} is preferably an aryl group or a monovalent heterocyclic group, and these groups may each have a substituent.

The definition and examples of the aryl group or the monovalent heterocyclic group represented by R^{H21} are the same as the definition and examples of the aryl group or the monovalent heterocyclic group represented by Ar^{H1} and Ar^{H2}.

The definition and examples of the optional substituent of R^{H21} are the same as the definitions and examples of the optional substituent of Ar^{H1} and Ar^{H2}.

The compound represented by formula (H-1) is preferably a compound represented by formula (H-2).

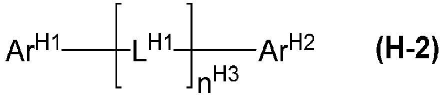

In the formula, Ar^{H1}, Ar^{H2}, n^{H3}, and L^{H1} represent the same meanings as described above.

Examples of the compound represented by formula (H-1) include the compounds represented by formula (H-101) to formula (H-118).

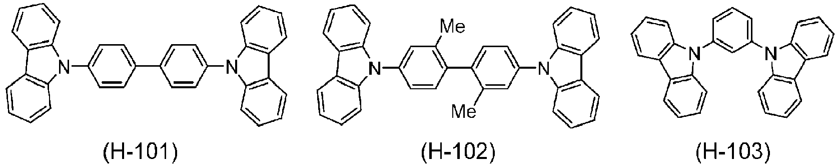

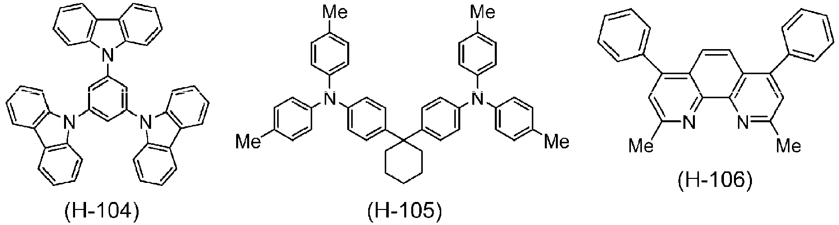

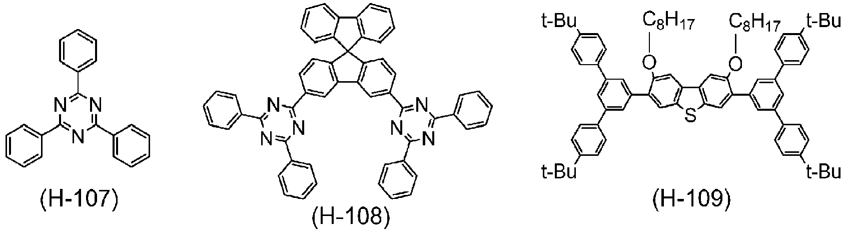

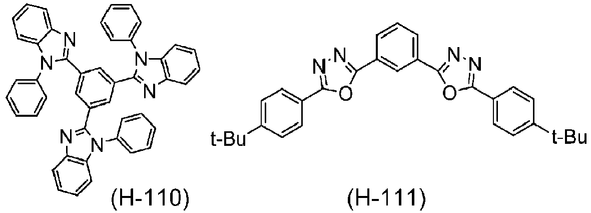

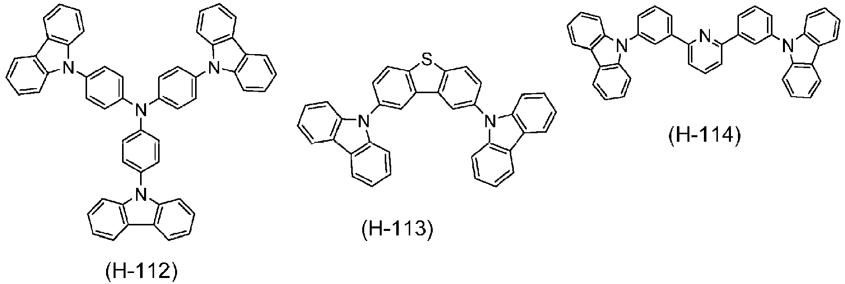

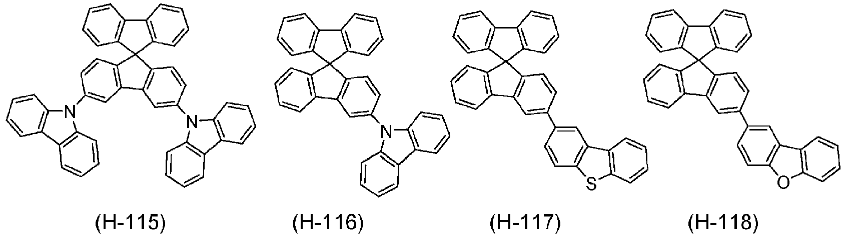

Examples of the polymer compound used for the host material include a polymer compound that serves as a hole transporting material (described later) and a polymer compound that serves as an electron transporting material (described later).

### [Light Emitting Layer Composition]

The light emitting layer may be a layer comprising a composition (hereinafter also referred to as "light emitting layer composition") comprising the metal complex represented by formula (1) and at least one selected from the group consisting of the above-mentioned host material, hole transporting material, hole injecting material, electron transporting material, electron injecting material, light emitting material (which is different from the metal complex represented by formula (1)), and an antioxidant.

### [Hole Transporting Material]

The hole transporting material is classified into a low molecular weight compound and a polymer compound, and a polymer compound is preferable. The hole transporting material may have a crosslinkable group.

Examples of the low molecular weight compounds include aromatic amine compounds such as triphenylamine and derivatives thereof, N,N'-di-1-naphthyl-N,N'-diphenylbenzidine (a-NPD), and N,N'-diphenyl-N,N'-di(m-tolyl)benzidine (TPD).

Examples of the polymer compounds include polyvinylcarbazole and derivatives thereof; and polyarylene having an aromatic amine structure in a side chain or main chain and derivatives thereof. The polymer compound may be a compound to which an electron accepting site is bound. Examples of the electron accepting moiety include fullerene, tetrafluorotetracyanoquinodimethane, tetracyanoethylene, trinitrofluorenone and the like, and fullerene is preferable.

In the composition of the light emitting layer, the content of the hole transporting material is usually 1 to 400 parts by mass and preferably 5 to 150 parts by mass, based on 100 parts by mass of the metal complex represented by formula (1).

One hole transporting material may be used alone, or two or more hole transporting materials may be used in combination.

### [Electron Transporting Material]

The electron transporting materials are classified into a low molecular weight compound and a polymer compound. The electron transporting material may have a crosslinkable group.

Examples of the low molecular weight compound include metal complexes having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene, and diphenoquinone, and derivatives of these.

Examples of the polymer compound include polyphenylene, polyfluorene, and derivatives thereof. The polymer compound may be doped with a metal.

In the light emitting layer composition, the content of the electron transporting material is, based on 100 parts by mass of the metal complex represented by formula (1), usually 1 to 400 parts by mass, and preferably 5 to 150 parts by mass.

One electron transporting material may be used alone, or two or more hole transporting materials may be used in combination.

### [Hole Injecting Material and Electron Injecting Material]

The hole injecting material and the electron injecting material are each classified into a low molecular weight compound and a polymer compound. The hole injecting material and the electron injecting material may have a crosslinkable group.

Examples of the low molecular weight compound include metal phthalocyanines such as copper phthalocyanine; carbon; metal oxides of molybdenum, tungsten, and the like; and metal fluorides such as lithium fluoride, sodium fluoride, cesium fluoride, and potassium fluoride.

Examples of the polymer compound include conductive polymers such as polyaniline, polythiophene, polypyrrole, polyphenylenevinylene, polythienylenevinylene, polyquinoline, and polyquinoxaline, and derivatives of these; and polymers comprising an aromatic amine structure in the main chain or side chain.

The content of the hole injecting material and the content of the electron injecting material in the light emitting layer composition are each usually 1 to 400 parts by mass and preferably 5 to 150 parts by mass, based on 100 parts by mass of the metal complex represented by formula (1).

One of each of the electron transporting material and the hole transporting material may be used alone, or two or more of each of the electron transporting material and the hole transporting material may be used in combination.

### (Ion Doping)

When the hole injecting material or the electron injecting material comprises a conductive polymer, the electrical conductivity of the conductive polymer is preferably 1 × 10⁻⁵ S/cm to 1 × 10³ S/cm. The conductive polymer can be doped with an appropriate amount of ions in order to set the electrical conductivity of the conductive polymer in such a range.

The type of ion to be doped is an anion for the hole injecting material and a cation for the electron injecting material. Examples of the anion include polystyrenesulfonic acid ions, alkylbenzenesulfonic acid ions, and camphorsulfonic acid ions. Examples of the cation include lithium ions, sodium ions, potassium ions, and tetrabutylammonium ions.

One type of ion to be doped may be used alone, or two or more types of ion to be doped may be used.

### [Light Emitting Material]

A light emitting material (different from the metal complex represented by formula (1)) is classified into a low molecular weight compound and a polymer compound. The light emitting material may have a crosslinkable group.

Examples of the low molecular weight compound include naphthalene and derivatives thereof, anthracene and derivatives thereof, perylene and derivatives thereof, and a triplet emission complex having iridium, platinum, or europium as a central metal.

Examples of the triplet emission complex include the following metal complexes.

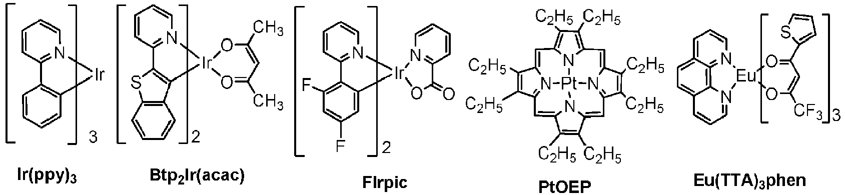

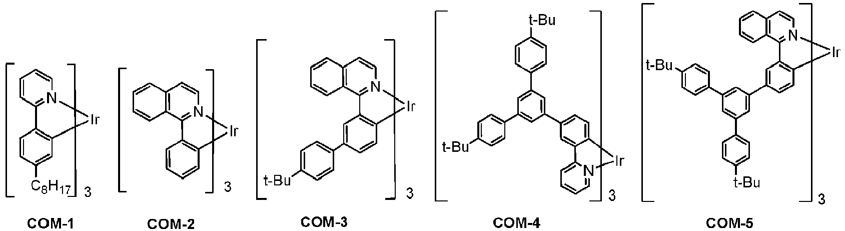

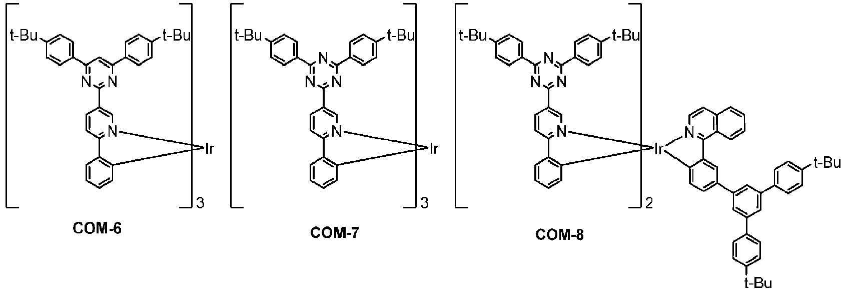

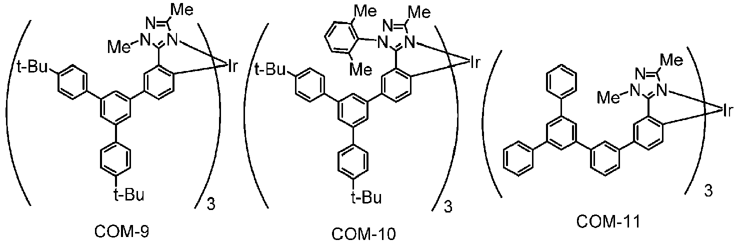

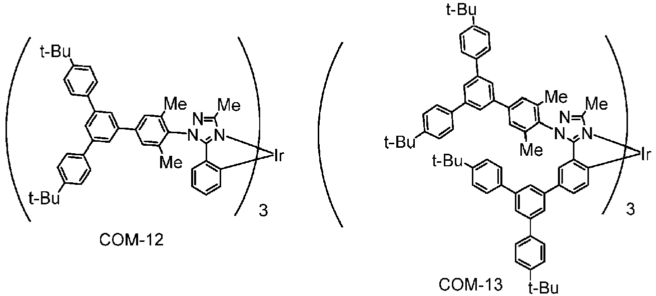

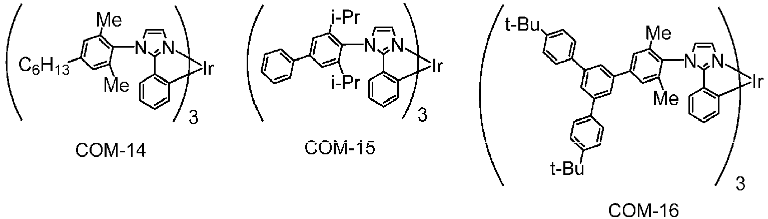

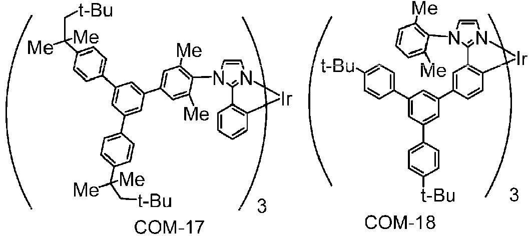

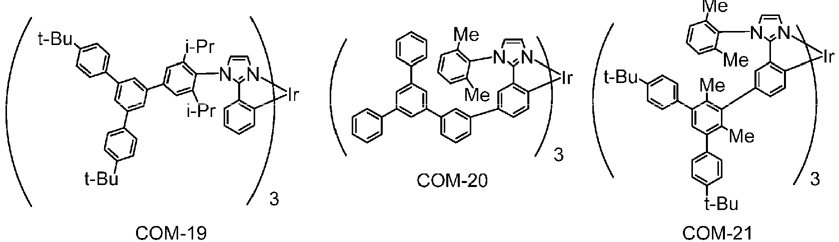

Examples of the polymer compound include polymer compounds including groups selected from arylene groups such as a phenylene group, a naphthalenediyl group, a fluorenediyl group, a phenanthrenediyl group, a dihydrophenanthrenediyl group, an anthracenediyl group and a pyrenediyl group; aromatic amine residues such as aromatic amine groups from which 2 hydrogen atoms are removed; and divalent heterocyclic groups such as a carbazolediyl group, a phenoxazinediyl group, and a phenothiazinediyl group.

The light emitting material is preferably a triplet emission complex or a polymer compound.

In the light emitting layer composition, the cotent of the light emitting material is, based on 100 parts by mass of the metal complex represented by formula (1), usually 1 to 400 parts by mass, and preferably 5 to 150 parts by mass.

One light emitting material may be used alone, or two or more light emitting materials may be used in combination.

### [Antioxidant]

The antioxidant is preferably a compound which is soluble in at least one solvent capable of dissolving, for example, a metal complex represented by formula (1) and does not inhibit light emission and charge transporting. Examples of the antioxidant include a phenol antioxidant and a phosphorus antioxidant.

The content of the antioxidant in the light emitting layer composition is usually 0.001 to 10 parts by mass, based on 100 parts by mass of the metal complex represented by formula (1).

One antioxidant may be used alone, or two or more antioxidants may be used in combination.

### <Metal Complex>

The metal complex according to the present embodiments is a metal complex represented by formula (1).

### <Ink of Light Emitting Layer>

The composition according to the present embodiment may be a composition comprising a metal complex represented by formula (1) and a solvent (hereinafter, also referred to as "ink of light emitting layer"). The ink of light emitting layer may be preferably used in a wet process such as spin coating, casting, micro gravure coating, gravure coating, bar coating, roll coating, wire bar coating, dip coating, spray coating, screen printing, flexographic printing, an offset printing method, ink jet printing, capillary coating, and nozzle coating.

The viscosity of the ink of the light emitting layer may be adjusted according to the type of coating method. When a solution of an ink jet printing method is applied in a printing method that employs an ejection apparatus, the viscosity is preferably 1 to 20 mPa·s at 25°C in order to prevent clogging and curved flight during ejection.

The solvent contained in the ink of the light emitting layer is preferably a solvent capable of dissolving or uniformly dispersing the solid content in the ink. Examples of the solvent include chlorinated solvents such as 1,2-dichloroethane, 1,1,2-trichloroethane, chlorobenzene, and o-dichlorobenzene; ether solvents such as tetrahydrofuran, dioxane, anisole, and 4-methylanisole; aromatic hydrocarbon solvents such as toluene, xylene, mesitylene, ethylbenzene, n-hexylbenzene, and cyclohexylbenzene; aliphatic hydrocarbon solvents such as cyclohexane, methylcyclohexane, n-pentane, n-hexane, n-heptane, n-octane, n-nonane, n-decane, n-dodecane, and bicyclohexyl; ketone solvents such as acetone, methyl ethyl ketone, cyclohexanone, and acetophenone; ester solvents such as ethyl acetate, butyl acetate, ethyl cellosolve acetate, methyl benzoate, and phenyl acetate; polyhydric alcohol solvents such as ethylene glycol, glycerin, and 1,2-hexanediol; alcohol solvents such as isopropyl alcohol and cyclohexanol; and sulfoxide solvents such as dimethylsulfoxide; amide solvents such as N-methyl-2-pyrrolidone and N,N-dimethylformamide. One solvent may be used alone, or two or more solvents may be used in combination.

The content of the solvent in the ink of the light emitting layer is usually 1000 to 100000 parts by mass and preferably 2000 to 20000 parts by mass, based on 100 parts by mass of the metal complex represented by formula (1)

### <Film>

The film according to the present embodiment is a film containing a metal complex represented by formula (1).

The film is preferable as a light emitting layer in a light emitting device.

The film may be produced using the ink of the light emitting layer, for example, by a wet process such as spin coating, casting, micro gravure coating, gravure coating, bar coating, roll coating, wire bar coating, dip coating, spray coating, screen printing, flexographic printing, an offset printing method, ink jet printing, capillary coating, and nozzle coating.

The thickness of the film is usually 1 nm to 10 µm.

### <Layer Structure of Light Emitting Device>

The light emitting device according to the present embodiment has an anode, a cathode, and a light emitting layer provided between the anode and the cathode. The light emitting device according to the present embodiment may further have a substrate.

The light emitting device according to the present embodiment may have a layer(s) (e.g., a hole transporting layer, an electron transporting layer, a hole injecting layer, an electron injecting layer, or the like) other than the anode, the cathode, and the light emitting layer.

A preferred form of the light emitting device according to the present embodiment is a light emitting device in which an anode is provided on a substrate, a light emitting layer is laminated on the anode, and a cathode is further laminated on the light emitting layer. Moreover, another preferred form of the light emitting device according to the present embodiment is a light emitting device in which a cathode is provided on a substrate, a light emitting layer is laminated on the cathode, and an anode is further laminated on the light emitting layer. In these forms, a layer(s) having another function(s) such as a protective layer, a buffer layer, a reflection layer, and a sealing layer (a sealing film, a sealing substrate, or the like) may further be provided.

The type of light emitting device according to the present embodiment may be any of a bottom emission type, a top emission type, and a double-sided light-emitting type.

The light emitting device according to the present embodiment preferably has at least one of a hole injecting layer and a hole transporting layer between the anode and the light emitting layer, from the viewpoint of hole injectability and hole transportability.

The light emitting device according to the present embodiment preferably has at least one of an electron injecting layer and an electron transporting layer between the cathode and the light emitting layer, from the viewpoint of electron injectability and electron transportability.

Examples of preferred layer structures of the light emitting device according to the present embodiment include the following structures.
(a) anode - hole transporting layer - light emitting layer - cathode
(b) anode - light emitting layer - electron transporting layer - cathode
(c) anode - hole injecting layer - hole transporting layer - light emitting layer - cathode
(d) anode - light emitting layer - electron transporting layer - electron injecting layer - cathode
(e) anode - hole transporting layer - light emitting layer - electron injecting layer - cathode
(f) anode - hole injecting layer - light emitting layer - electron transporting layer - cathode
(g) anode - hole injecting layer - hole transporting layer - light emitting layer - electron injecting layer - cathode
(h) anode - hole injecting layer - light emitting layer - electron transporting layer - electron injecting layer - cathode
(i) anode - hole injecting layer - hole transporting layer - light emitting layer - electron transporting layer - electron injecting layer - cathode
(j) anode - hole transporting layer - light emitting layer - electron transporting layer - cathode
(k) anode - hole injecting layer - hole transporting layer - light emitting layer - electron transporting layer - cathode
(l) anode - hole transporting layer - light emitting layer - electron transporting layer - electron injecting layer - cathode

To improve adhesion between the electrodes and other layers and to improve charge injecting from the electrodes, the light emitting device according to the present embodiment may be provided with an insulating layer adjacent to the electrodes. In addition, to improve adhesion at the interfaces and to prevent components from two adjacent layers from mixing, in the light emitting device according to the present embodiment, a thin buffer layer may be inserted at the interfaces between the layers. The order and number of layers to be laminated and the thickness of each layer may be adjusted in consideration of external quantum efficiency and device life.

Next, the configuration of the light emitting device according to the present embodiment will be described in detail.

### [Substrate]

The light emitting device according to the present embodiment may have a substrate on the side opposite to the light emitting layer side of the anode or on the side opposite to the light emitting layer side of the cathode. The substrate is preferably a substrate that does not chemically change when forming the electrodes and organic layers (e.g., the light emitting layer, the hole transporting layer, the hole injecting layer, the electron transporting layer, the electron injecting layer, etc.). The substrate may be a substrate made of, for example, glass, plastic, a polymer film, a metal film, silicon, or the like or a laminated substrate thereof.

In the light emitting device according to the present embodiment, two or more layers of the anode, the hole injecting layer, the hole transporting layer, the electron transporting layer, the electron injecting layer, and the cathode may be provided, as necessary.

When there are a plurality of anodes, hole injecting layers, hole transporting layers, the light emitting layer, electron transporting layers, electron injecting layers, and cathodes, the materials composing them may be the same or different from each other.

The thickness of the anode, the hole injecting layer, the hole transporting layer, the light emitting layer, the electron transporting layer, the electron injecting layer, and the cathode is usually 1 nm to 1 µm, preferably 2 nm to 500 nm, and more preferably 5 nm to 150 nm.

It is preferable that the materials composing the hole injecting layer, the light emitting layer, the hole transporting layer, the electron transporting layer, and the electron injecting layer are not dissolved in the solvents used in the formation of the adjacent layers. Preferable methods for avoiding dissolution of the materials include: i) a method in which materials having a crosslinkable group are used, or ii) a method in which a difference in solubility from that of the adjacent layer. In the method i), it is possible to prevent the layer from dissolving by forming the layer using a material having a crosslinkable group and then crosslinking the crosslinkable group.

### [Hole Injecting Layer and Electron Injecting Layer]

The hole injecting layer is a layer comprising a hole injecting material. Examples of the hole injecting material include the hole injecting material that may be contained in the above-mentioned light emitting layer composition. One hole injecting material may be contained alone, or two or more hole injecting materials may be contained in combination.

The electron injecting layer is a layer comprising an electron injecting material. Examples of the electron injecting material include the electron injecting material that may be contained in the above-mentioned light emitting layer composition. One electron injecting material may be contained alone, or two or more electron injecting materials may be contained in combination.

### [Hole Transporting Layer]

The hole transporting layer is a layer comprising a hole transporting material. Examples of the hole transporting material include the hole transporting material that may be contained in the above-mentioned light emitting layer composition. One hole transporting material may be contained alone, or two or more hole transporting materials may be contained in combination.

### [Electron transporting layer]

The electron transporting layer is a layer comprising an electron transporting material. Examples of the electron transporting material include the electron transporting materials which the light emitting layer composition may comprise as described above. One electron transporting material alone or two or more electron transporting materials may be contained.

### [Electrodes]

Examples of the material of the anode include conductive metal oxides and translucent metals. The anode material is preferably indium oxide, zinc oxide, or tin oxide; a conductive compound such as indium tin oxide (ITO) or indium zinc oxide; a complex of silver, palladium, and copper (APC); NESA, gold, platinum, silver, or copper.

Examples of the material of the cathode include metals such as lithium, sodium, potassium, rubidium, cesium, beryllium, magnesium, calcium, strontium, barium, aluminum, zinc, and indium; alloys of two or more of those metals; alloys of one or more of those metals with one or more of silver, copper, manganese, titanium, cobalt, nickel, tungsten, and tin; and graphite and graphite intercalation compounds. Examples of the alloys include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

In the light emitting device according to the present embodiment, at least one of the anode and the cathode is usually transparent or translucent, but it is preferable that the anode is transparent or translucent.

Examples of a method for forming the anode and the cathode include vacuum deposition, sputtering, ion plating, plating, and lamination.

### [Method for Producing Light Emitting Device]

Examples of methods for forming layers such as the light emitting layer, the hole transporting layer, the electron transporting layer, the hole injecting layer, and the electron injecting layer in the light emitting device according to the present embodiment include vacuum deposition, wet processes represented by spin coating and ink jet printing, and the like, and the wet processes are preferable. In the case of using a low molecular weight compound, examples of such methods include vacuum deposition from powder and methods of forming a film from a solution or a molten state. In the case of using a polymer compound, examples of such methods include methods of forming a film from a solution or a molten state

The light emitting layer may be formed using the ink of the light emitting layer and the hole transporting layer, the electron transporting layer, the hole injecting layer, and the electron injecting layer may be formed respectively using inks containing the hole transporting material, the electron transporting material, the hole injecting material, and the electron injecting material described above by a wet process represented by spin coating and ink jet printing.

The light emitting device according to the present embodiment can be produced, for example, by sequentially layering the layers on the substrate. Specifically, the light emitting device can be produced, for example, by providing an anode on a substrate, providing a layer(s) such as a hole injecting layer and a hole transporting layer on the anode, providing a light emitting layer thereon, providing a layer(s) such as an electron transporting layer and an electron injecting layer on the light emitting layer, and further layering a cathode thereon. In another method of production, the light emitting device can be produced, for example, by providing a cathode on a substrate, providing a layer(s) such as an electron injecting layer, an electron transporting layer, a light emitting layer, a hole transporting layer, a hole injecting layer on the cathode, and further layering an anode thereon. In a further method of production, the light emitting device can be produced, for example, by joining an anode or an anode side base in which layers are laminated on an anode and a cathode or a cathode side base in which layers are laminated on a cathode face by face.

### [Light emitting device Applications]

To obtain planar light emission using a light emitting device, a planar anode and a planar cathode may be arranged so as to overlap each other. Examples of methods for obtaining patterned light emission include a method in which a mask having a patterned window is disposed on the surface of a planar light emitting device, a method in which a layer that is not intended to emit light is formed very thickly so as to substantially prevent light emission, and a method in which the anode or the cathode, or both electrodes, are formed in a pattern shape. By forming a pattern by any of these methods and arranging such that several electrodes can be independently switched ON/OFF, a segment type display device capable of displaying numerals, letters, and the like is obtained. To obtain a dot matrix display device, the anodes and the cathodes are formed in a striped shape so as to be orthogonal to each other. Partial color display and multi-color display can be achieved by a method in which a plurality of polymer compounds having different emission colors are used for separate paining or a method in which a color filter or a fluorescence conversion filter are used. A dot matrix display device can be driven passively, or can be driven actively in combination with TFT and the like. These display devices can be used as a display in computers, television sets, mobile terminals, and the like. A planar light emitting device can be suitably used as a planar light source for a backlight in a liquid crystal display or as a planar illumination light source. When a flexible substrate is used, the light emitting device can also be used as a curved light source and a curved display.

Preferred embodiments of the present invention have been described in the foregoing, but the present invention is not limited to the embodiments described above.

### Examples

The present invention will now be described in more detail by the following Examples, but the present invention is not limited to these Examples.

In the Examples, the polystyrene-equivalent number-average molecular weight (Mn) and the polystyrene-equivalent weight-average molecular weight (Mw) of the polymer compounds were determined by size-exclusion chromatography (SEC) (trade name: LC-10Avp made by Shimadzu Corporation). The SEC measurement conditions were as follows.

### [Measurement conditions]

The polymer compound to be measured was dissolved at a concentration of about 0.05% by mass in tetrahydrofuran (THF), and 10 µL of the solution was injected into the SEC column. THF was used as the mobile phase in SEC and the flow rate was 2.0 mL/ minute. PLgel MIXED-B (manufactured by Polymer Laboratories, Ltd.) was used as the column. A UV-VIS detector (trade name: SPD-10Avp, made by Shimadzu Corporation) was used as the detector.

### LC-MS was measured by the following method.

The measurement sample was dissolved in chloroform or tetrahydrofuran so as to have a concentration of about 2 mg/mL, and about 1 µL was injected into an LC-MS (trade name: 1100 LC-MSD, manufactured by Agilent). The LC-MS mobile phase was flowed at a rate of 0.2 mL/min while varying the ratio of acetonitrile and tetrahydrofuran. An L-column 2 ODS (3 µm) (manufactured by the Chemicals Evaluation and Research Institute, inner diameter: 2.1 mm, length: 100 mm, particle diameter 3 µm) was used for the column.

### NMR was measured by the following method.

A measurement sample of 5 to 10 mg was dissolved in about 0.5 mL of deuterated chloroform (CDCl₃), heavy tetrahydrofuran, heavy dimethyl sulfoxide, heavy acetone, heavy N,N-dimethylformamide, heavy toluene, heavy methanol, heavy ethanol, heavy 2-propanol, or heavy methylene chloride, and measured using an NMR apparatus (trade name: INOVA 300 or MERCURY 400 VX, manufactured by Varian, Inc. or trade name: AVANCE 600, manufactured by Bruker).

As an index of the purity of the compound, the value of the high-performance liquid chromatography (HPLC) area percentage was used. Unless noted otherwise, this value is the value at UV=254 nm in the HPLC apparatus (product name: LC-20A, manufactured by Shimadzu Corporation). At this time, the compound to be measured was dissolved in tetrahydrofuran or chloroform so as to have a concentration of 0.01 to 0.2% by mass, and 1 to 10 µL was injected into the HPLC apparatus in accordance with the concentration. For the HPLC mobile phase, the ratio of acetonitrile/tetrahydrofuran was varied between 100/0 to 0/100 (volume ratio) while flowing at a flow rate of 1.0 mL/min. As the column, a Kaseisorb LC ODS 2000 (manufactured by Tokyo Chemical Industry) or an ODS column having equivalent performance was used. For the detector, a photodiode array detector (trade name: SPD-M20A, manufactured by Shimadzu Corporation) was used.

### <Synthesis Examples M1 to M3> Synthesis of Compounds M1 to M3

Compound M1 was synthesized according to the methods described in International Publication No. 2015/145871.

Compound M2 was synthesized according to the methods described in International Publication No. 2013/146806.

Compound M3 was synthesized according to the methods described in International Publication No. 2005/049546.

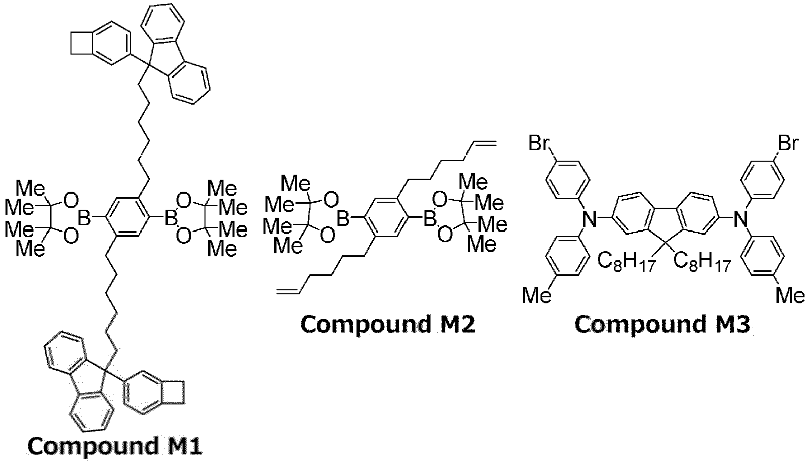

### <Synthesis Example HTL1> Synthesis of Polymer compound HTL-1

Polymer compound HTL-1 was synthesized according to the methods described in International Publication No. 2015/145871 using compound M1, compound M2 and compound M3. The polystyrene-equivalent number-average molecular weight and the polystyrene-equivalent weight-average molecular weight of polymer compound HTL-1 were Mn = 2.3 × 10⁴ and Mw = 1.2 × 10⁵, respectively.

The polymer compound HTL-1 was a copolymer having, based on the theoretical values obtained from the amounts of the charged raw materials, a molar ratio among the constitutional unit derived from compound M1, the constitutional unit derived from compound M2, and the constitutional unit derived from compound M3 of 45:5:50.

### <Synthesis Example ET1> Synthesis of Polymer compound ET1

### (Synthesis of Polymer compound ET1a)

Polymer compound ET1a was synthesized according to the methods described in Japanese Unexamined Patent Publication No. 2012-33845 using compound ET1-1 synthesized in accordance with the method described in Japanese Unexamined Patent Publication No. 2012-33845 and compound ET1-2 synthesized in accordance with the method described in Japanese Unexamined Patent Publication No. 2012-33845.

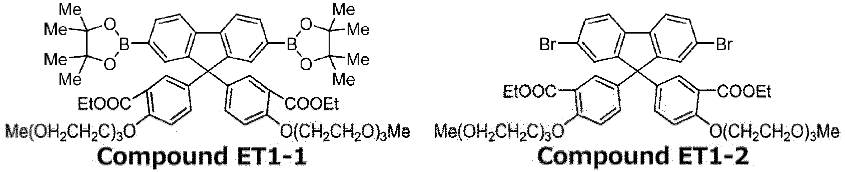

The Mn of polymer compound ET1a was 5.2 × 10⁴.

The polymer compound ET1a was a copolymer having, based on the theoretical values obtained from the amounts of the charged raw materials, a molar ratio among the constitutional unit derived from compound ET1-1 and the constitutional unit derived from compound ET1-2 of 50:50.

### (Synthesis of Polymer compound ET1)

The atmosphere within a reaction vessel was replaced with an inert gas, then the reaction vessel was charged with polymer compound ET1a (200 mg), tetrahydrofuran (20 mL), and ethanol (20 ml), and the mixture was heated to 55°C. Then, cesium hydroxide (200 mg) dissolved in water (2 mL) was added thereto, and the mixture was stirred at 55°C for 6 hours. Then, the mixture was cooled to room temperature, and then concentrated under reduced pressure to obtain a solid. The obtained solid was washed with water, and then dried under reduced pressure to obtain polymer compound ET1 (150 mg, light yellow solid). Based on NMR spectrum of the obtained polymer compound ET1, it was confirmed that the signal derived from the ethyl group at the ethyl ester site in polymer compound ET1a had completely disappeared.

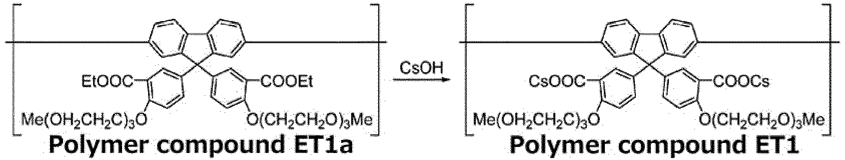

### <Example 1> Synthesis of Metal complex E1

Metal complex E1 was synthesized by the following method.

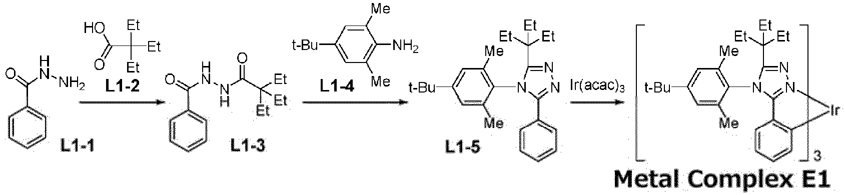

### (Synthesis of Reaction mixture LI-2')

The atmosphere within a reaction vessel was replaced with nitrogen, then the reaction vessel was charged with compound LI-2 (50 g) and thionyl chloride (100 mL), and the mixture was stirred under reflux for 3 hours. Then, the reaction mixture was cooled to room temperature and thionyl chloride was distilled off under reduced pressure to obtain reaction mixture L1-2'.

### (Synthesis of Compound LI-3)

The atmosphere within a reaction vessel was replaced with nitrogen, then the reaction vessel was charged with compound L1-1 (47 g) and tetrahydrofuran (1L), and the mixture was cooled to 0°C. Triethylamine (54 mL) was slowly added thereto and the mixture was stirred at 0°C for 45 minutes. The reaction mixture LI-2' (whole amount) obtained in (Synthesis of Reaction mixture LI-2') was slowly added thereto. Then, the mixture was stirred at room temperature for 16 hours. The obtained reaction solution was filtered, and then the obtained filtrate was concentrated under reduced pressure to obtain a crude product. The obtained crude product was washed with a mixed solvent of ethyl acetate and hexane, and then dried under reduced pressure to obtain compound LI-3 (50 g). The HPLC area percentage value of compound LI-3 was 95.2%. The required amount of compound L1-3 was obtained by repeating this operation.

The results of analysis of compound L1-3 were as follows.
LC-MS (APCI, positive): m/z = 263 [M+H]⁺
¹H-NMR (300 MHz, CDCl₃): δ (ppm) = 0.84 (t, 9H), 1.64 (q, 6H), 7.39-7.54 (m, 3H), 7.81-7.84 (m, 2H), 8.72-8.74 (m, 1H), 9.66-9.68 (m, 1H).

### (Synthesis of Compound L1-5)

The atmosphere within a reaction vessel was replaced with nitrogen, then the reaction vessel was charged with compound LI-3 (58 g) and toluene (600 mL), and the mixture was stirred at room temperature. Phosphorus pentachloride (92 g) was slowly added thereto and then the mixture was stirred at 110°C for 3 hours. Then, the obtained reaction solution was cooled to room temperature, and compound LI-4 (78.2 g) and p-toluenesulfonic acid (3 g) were added thereto. Subsequently, the mixture was stirred at 130°C for 4 days, and then the reaction solution was cooled to room temperature. The obtained reaction solution was concentrated under reduced pressure, ethyl acetate (2 L) was added thereto, and then the mixture was washed with an aqueous 10% by mass sodium hydrogen carbonate solution. The obtained organic layer was dried over magnesium sulfate and then filtered, and the obtained filtrate was concentrated under reduced pressure to obtain a crude product. The crude product was purified by silica gel column chromatography (mixed solvent of methanol and chloroform), furthermore crystallized from acetonitrile, and then dried under reduced pressure to obtain compound LI-5 (6 g). The HPLC area percentage value of compound L1-5 was 99.1%.

The results of analysis of compound LI-5 were as follows.
LC-MS (APCI, positive): m/z = 404 [M+H]⁺
¹H-NMR (400 MHz, CDCl₃): δ (ppm) = 0.83 (t, 9H), 1.34 (s, 9H), 1.64 (q, 6H), 1.96 (s, 6H), 7.12 (s, 2H), 7.20-7.23 (m, 2H), 7.28-7.34 (m, 3H).

### (Synthesis of Metal complex E1)

The atmosphere within a reaction vessel was replaced with nitrogen, then the reaction vessel was charged with tris(acetylacetonato)iridium (III) (1.4 g), compound L1-5 (4.6 g) and pentadecane (2 mL), and the mixture was stirred at 300°C for 18 hours. Then, the obtained reaction solution was cooled to room temperature, toluene was added thereto to dissolve the components, and the reaction solution was concentrated under reduced pressure to obtain a crude product. The obtained crude product was purified by silica gel column chromatography (mixed solvent of heptane and ethyl acetate), furthermore crystallized from a mixed solvent of acetonitrile and toluene, and then dried under reduced pressure to obtain metal complex E1 (2.8 g). The HPLC area percentage value of metal complex E1 was 99.5% or more.

The results of analysis of metal complex E1 were as follows.
¹H-NMR (600 MHz, THF-d₈): δ (ppm) = 7.30 (s, 6H), 6.90 (d, 3H), 6.44-6.48 (m, 3H), 6.22-6.26 (m, 3H), 5.77 (d, 3H), 2.10 (s, 9H), 1.89 (s, 9H), 1.56 (s, 18H), 1.38 (s, 27H), 0.73 (t, 27H).

### <Example 2> Synthesis of Metal complex E2

Metal complex E2 was synthesized by the following method.

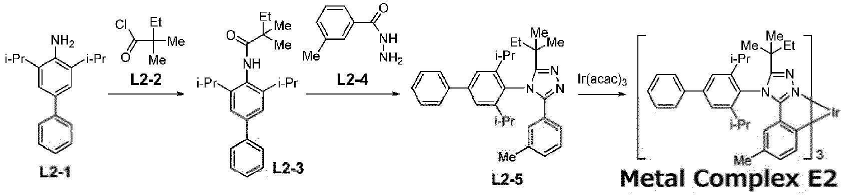

### (Synthesis of Compound L2-3)

The atmosphere within a reaction vessel was replaced with nitrogen, then the reaction vessel was charged with compound L2-1 (21.4 g), triethylamine (13.0 mL) and tetrahydrofuran (300 mL), and the mixture was cooled to 0°C. Compound L2-2 (12.8 mL) was added dropwise thereto, and then the mixture was stirred at room temperature for 16 hours. Then, ion exchange water (100 mL) was added thereto, whereupon a precipitate formed. The reaction solution forming the precipitate was filtered to obtain residue L2-3-1 and filtrate L2-3-2. Residue L2-3-1 was washed with toluene, and then dried under reduced pressure to obtain solid L2-3' (24.5 g). Furthermore, the aqueous layer was removed from filtrate L2-3-2, and the obtained organic layer was dried over magnesium sulfate and filtered. The obtained filtrate was concentrated under reduced pressure, and then crystallized from a mixed solvent of toluene and heptane. Subsequently, the obtained solid was dried under reduced pressure to obtain solid L2-3" (3.9 g).

Solid L2-3' and solid L2-3" obtained above were combined, then crystallized from a mixed solvent of toluene and heptane, and furthermore dried under reduced pressure to obtain compound L2-3 (27.8 g, white solid). The HPLC area percentage value of compound L2-3 was 98.9%.

The results of analysis of compound L2-3 were as follows.
¹H-NMR (600 MHz, THF-d₈): δ (ppm) = 7.57 (d, 2H), 7.43 (t, 2H), 7.35 (s, 2H), 7.34 (t, 1H), 6.82 (brs, 1H), 3.08 (septet, 2H), 1.73 (q, 2H), 1.34 (s, 6H), 1.25 (d, 12H), 1.00 (t, 3H).

### (Synthesis of Compound L2-5)

Compound L2-5 was synthesized using compound L2-3 (19.1 g), chlorobenzene (150 mL), 2-fluoropyridine (5.15 mL) and trifluoromethanesulfonic anhydride (10.0 mL) according to the method described in Organic Letters, Vol. 17, pp. 1184-1187, 2015.

The results of analysis of compound L2-5 were as follows.
¹H-NMR (600 MHz, CDCl₃): δ (ppm) = 7.68 (d, 2H), 7.52 (t, 2H), 7.50 (s, 2H), 7.43 (t, 1H), 7.26 (s, 1H), 7.05-6.98 (m, 3H), 2.53 (septet, 2H), 2.15 (s, 3H), 1.88 (q, 2H), 1.28 (d, 6H), 1.23 (s, 6H), 0.89 (t, 3H), 0.77 (d, 6H).

### (Synthesis of Metal complex E2)

The atmosphere within a reaction vessel was replaced with nitrogen, then the reaction vessel was charged with tris(acetylacetonato)iridium (III) (0.72 g), compound L2-5 (2.8 g) and pentadecane (2 mL), and the mixture was stirred at 300°C for 24 hours. Then, the obtained reaction solution was cooled to room temperature, and purified by silica gel column chromatography (mixed solvent of methylene chloride and ethyl acetate), and furthermore the resultant was crystallized sequentially from a mixed solvent of acetonitrile and toluene, a mixed solvent of toluene and methanol, and a mixed solvent of methylene chloride and acetonitrile. The obtained solid was washed with methylene chloride, and then dried under reduced pressure to obtain metal complex E2 (0.82 g). The HPLC area percentage value of metal complex E2 was 98.8%.

The results of analysis of metal complex E2 were as follows.
¹H-NMR (600 MHz, THF-d₈): δ (ppm) = 7.74 (d, 6H), 7.64 (dd, 6H), 7.48 (t, 6H), 7.38 (t, 3H), 6.68 (d, 3H), 6.30 (d, 3H), 5.62 (s, 3H), 2.94 (septet, 3H), 2.37 (septet, 3H), 1.75 (s, 9H), 1.71-1.64 (m, 6H), 1.34 (d, 9H), 1.22-1.17 (m, 27H), 0.98 (d, 9H), 0.90 (d, 9H), 0.81 (d, 9H).

### <Comparative Example 1> Synthesis of Metal complex CE1

Metal complex CE1 was synthesized by the following method.

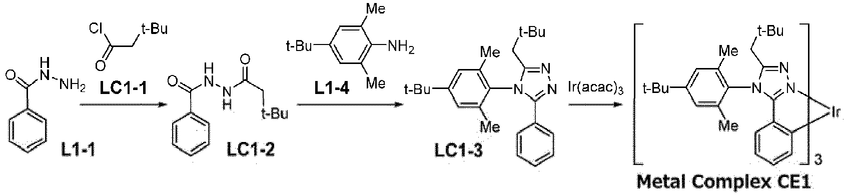

### (Synthesis of Compound LC1-2)

The atmosphere within a reaction vessel was replaced with nitrogen, then the reaction vessel was charged with compound L1-1 (100 g) and tetrahydrofuran (1 L), and the mixture was cooled to 0°C. Triethylamine (54 mL) was slowly added thereto and the mixture was stirred at 0°C for 10 minutes. Compound LC1-1 was added dropwise thereto, and then the mixture was stirred at room temperature for 16 hours. The obtained reaction solution was concentrated under reduced pressure, and then ion exchange water was added thereto and the mixture was stirred for 1 hour, whereupon a solid formed. The obtained solid was collected by filtration, furthermore washed with ethyl acetate, and then dried under reduced pressure to obtain compound LCI-2 (110 g). The HPLC area percentage value of compound LCI-2 was 99.5% or more.

The results of analysis of compound LC1-2 were as follows.
¹H-NMR (400 MHz, DMSO-d₆): δ (ppm) = 1.03 (s, 9H), 2.07 (s, 2H), 7.48-7.60 (m, 3H), 7.87-7.89 (m, 2H), 9.74 (s, 1H), 10.26 (s, 1H).

### (Synthesis of Compound LC1-3)

The atmosphere within a reaction vessel was replaced with nitrogen, then the reaction vessel was charged with compound LCI-2 (40 g) and xylene (400 mL), and the mixture was cooled to 0°C. Compound L1-4 (36.3 g) was added thereto and the mixture was stirred at 0°C for 10 minutes. Phosphorus pentachloride (53.3 g) was added dropwise thereto and the mixture was stirred at 130°C for 5 days. Then, the obtained reaction solution was cooled to room temperature and concentrated under reduced pressure. The obtained reaction mixture was extracted with ethyl acetated and a saturated aqueous sodium hydrogen carbonate solution. The obtained organic layer was washed with water and saturated brine in that order. Then, the obtained organic layer was dried over magnesium sulfate and filtered, and the obtained filtrate was concentrated under reduced pressure to obtain a crude product. The obtained crude product was purified sequentially by silica gel column chromatography (mixed solvent of hexane and ethyl acetate) and by reversed-phase column chromatography (mixed solvent of water and acetonitrile), and furthermore the resultant was dried under reduced pressure to obtain compound LC1-3 (8 g). The HPLC area percentage value of compound LC1-3 was 99.5%.

The results of analysis of compound LC1-3 were as follows.
LC-MS (APCI, positive): m/z = 376 [M+H]⁺
¹H-NMR (400 MHz, CDCl₃): δ (ppm) = 1.09 (s, 9H), 1.36 (s, 9H), 1.90 (s, 6H), 2.35 (s, 2H), 7.17 (s, 2H), 7.22-7.31 (m, 3H), 7.37-7.39 (m, 2H).

### (Synthesis of Metal complex CE1)

The atmosphere within a reaction vessel was replaced with nitrogen, then the reaction vessel was charged with tris(acetylacetonato)iridium (III) (1.5 g), compound LC1-3 (5.8 g) and pentadecane (2 mL), and the mixture was stirred at 300°C for 22 hours. Then, the obtained reaction solution was cooled to room temperature, toluene was added thereto to dissolve the components, and the reaction solution was concentrated under reduced pressure to obtain a crude product. The obtained crude product was purified by silica gel column chromatography (mixed solvent of heptane and ethyl acetate), and crystallized from a mixed solvent of toluene and heptane, and then dried under reduced pressure to obtain metal complex CE1 (1.8 g) The HPLC area percentage value of metal complex CE1 was 99.5% or more.

The results of analysis of metal complex CE1 were as follows.
¹H-NMR (600 MHz, THF-d₈): δ (ppm) = 7.33 (s, 6H), 6.91-6.94 (m, 3H), 6.50 (td, 3H), 6.30-6.34 (m, 3H), 6.09-6.12 (m, 3H), 2.21-2.25 (m, 3H), 2.13-2.16 (m, 3H), 2.09 (s, 9H), 1.86 (s, 9H), 1.36-1.42 (m, 27H), 1.00-1.04 (m, 27H).

### <Example D1> Fabrication and Evaluation of Light Emitting Device D1

### (Formation of Anode and Hole Injection Layer)

An ITO film with a thickness of 45 nm was attached to a glass substrate by a sputtering method to form an anode. On the anode, a polythiophene-sulfonic acid type hole injection material AQ-1200 (manufactured by Plextronics) was spin-coated to form a film with a thickness of 35 nm, and the film was heated on a hot plate at 170°C for 15 minutes under an air atmosphere to form a hole injection layer.

### (Formation of Hole Transporting Layer)

A polymer compound HTL-1 was dissolved at a concentration of 0.7% by mass in xylene. The resultant xylene solution was spin-coated on the hole injection layer to form a film with a thickness of 20 nm, and the film was heated on a hot plate at 180°C for 60 minutes under a nitrogen gas atmosphere to form a hole transporting layer.

### (Formation of Light Emitting Layer)

A compound HM-1 and a metal complex E1 (compound HM-1/metal complex E1 = 75% by mass/25% by mass) were dissolved at a concentration of 2% by mass in toluene. The resultant toluene solution was spin-coated on the hole transporting layer to form a film with a thickness of 75 nm, and the film was heated at 130°C for 10 minutes under a nitrogen gas atmosphere to form a light emitting layer. A compound purchased from Luminescence Technology Corp. was used as compound HM-1.

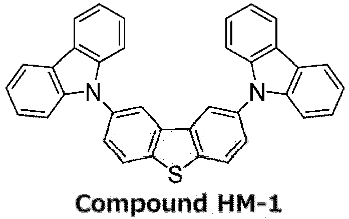

### (Formation of Electron Transporting Layer)

A polymer compound ET1 was dissolved at a concentration of 0.25% by mass in 2,2,3,3,4,4,5,5-octafluoro-1-pentanol. The resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere to form an electron transporting layer.

### (Formation of Cathode)

The substrate on which the electron transporting layer was formed was placed in a vapor deposition machine, and the pressure was reduced to 1.0 × 10⁻⁴ Pa or less. Then, as a cathode, sodium fluoride was vapor-deposited to a thickness of about 4 nm on the electron transporting layer, and then aluminum was vapor-deposited to a thickness of about 80 nm on the sodium fluoride layer. After the vapor deposition, sealing was performed using a glass substrate to fabricate a light emitting device D1.

### (Evaluation of Light Emitting Device)

EL emission was observed by applying a voltage to the light emitting device D1. The chromaticity coordinate (x, y) at 3000 cd/m² was (0.18, 0.35). After setting the current value so that the initial luminance was 3000 cd/m², the light emitting device D1 was driven at a constant current, and the time until the luminance reached 95% of the initial luminance was measured to be 10.6 hours.

### <Example D2> Fabrication and Evaluation of Light Emitting Device D2

A light emitting device D2 was fabricated in the same manner as in Example D1, except that "a compound HM-1 and a metal complex E2 (compound HM-1/metal complex E2=75% by mass/25% by mass)" was used in place of "a compound HM-1 and a metal complex E1 (compound HM-1/metal complex E1=75% by mass/25% by mass)" in the (Formation of Light Emitting Layer) of Example D1. EL emission was observed by applying a voltage to the light emitting device D2. The chromaticity coordinate (x, y) at 3000 cd/m² was (0.21, 0.45). After setting the current value so that the initial luminance was 3000 cd/m², the light emitting device D2 was driven at a constant current, and the time until the luminance reached 95% of the initial luminance was measured to be 18.1 hours.

### <Comparative Example CD1> Fabrication and Evaluation of Light Emitting Device CD1

A light emitting device CD1 was fabricated in the same manner as in Example D1, except that "a compound HM-1and a metal complex CE1 (compound HM-1/metal complex CE1=75% by mass/25% by mass)" was used in place of "a compound HM-1 and a metal complex E1 (compound HM-1/metal complex E1=75% by mass/25% by mass/1% by mass)" in the (Formation of Light Emitting Layer) of Example D1. EL emission was observed by applying a voltage to the light emitting device CD1. The chromaticity coordinate (x, y) at 3000 cd/m² was (0.18, 0.35). After setting the current value so that the initial luminance was 3000 cd/m², the light emitting device CD1 was driven at a constant current, and the time until the luminance reached 95% of the initial luminance was measured to be 1.4 hours.

**[Table 1]**

| | Light emitting device | Light emitting layer | | Luminance lifetime (hour) |
|---|---|---|---|---|
| | | Constituent material | Composition ratio (mass ratio) | |
| Example D1 | D1 | HM-1/E1 | 75/25 | 10.6 |
| Example D2 | D2 | HM-1/E2 | 75/25 | 18.1 |
| Comparative Example CD1 | CD1 | HM-1/CE1 | 75/25 | 1.4 |

### Industrial Applicability

According to the present invention, a light emitting device which shows an excellent luminance lifetime can be provided. Furthermore, according to the present invention, a metal complex and a composition useful for manufacturing a light emitting device which shows an excellent luminance lifetime can be provided.

## Claims

1. A light emitting device, comprising:
an anode;
a cathode; and
a light emitting layer provided between the anode and the cathode,
wherein the light emitting layer comprises a metal complex represented by formula (1), 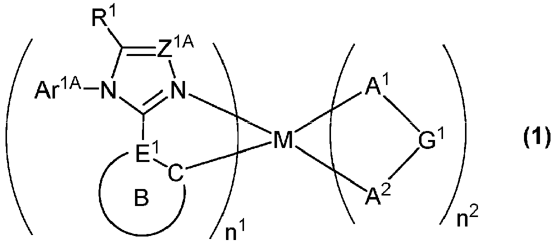 wherein,
M represents a rhodium atom, a palladium atom, an iridium atom or a platinum atom,
when M is a rhodium atom or an iridium atom, n¹ is 2 or 3; when M is a palladium atom or a platinum atom, n¹ is 2,
n² represents an integer of 0 or more, and n¹ + n² is 2 or 3,
when M is a rhodium atom or an iridium atom, n¹ + n² is 3, and when M is a palladium atom or a platinum atom, n¹ + n² is 2,
E¹ represents a carbon atom or a nitrogen atom; and when there are a plurality of E¹, they may be the same or different,
the ring B represents an aromatic hydrocarbon ring or an aromatic heterocyclic ring, and these rings may each have a substituent; when there are a plurality of the substituents, they may be bonded to each other to form a ring together with the atoms to which they are bonded; and when there are a plurality of the ring B, they may be the same or different,
Z^{1A} represents a group represented by =N- or a group represented by =C(R^{Z1A})-; when there are a plurality of Z^{1A}, they may be the same or different; and R^{Z1A} represents a hydrogen atom, an alkyl group, a cycloalkyl group, an alkoxy group, a cycloalkoxy group, an aryl group, an aryloxy group, or a monovalent heterocyclic group, a substituted amino group, or a halogen atom, and these groups may each have a substituent,
R¹ represents a tertiary alkyl group having n^{R1} carbon atoms, and the group may have a substituent; when there are a plurality of R¹, they may be the same or different; and n^{R1} represents an integer of 4 or more and 15 or less,
Ar^{1A} represents a group represented by formula (Ar-1A); and when there are a plurality of Ar^{1A}, they may be the same or different, and
A¹-G¹-A² represents an anionic bidentate ligand; A¹ and A² each independently represent a carbon atom, an oxygen atom or a nitrogen atom, and these atoms may each be an atom constituting a ring; G¹ represents a single bond or an atomic group constituting the bidentate ligand together with A¹ and A²; and when there are a plurality of A¹-G¹-A², they may be the same or different, 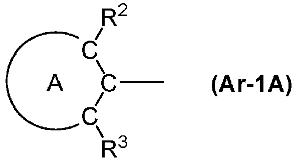 wherein,
the ring A represents an aromatic hydrocarbon ring or an aromatic heterocyclic ring, and these rings may each have a substituent; and when there are a plurality of the substituents, they may be bonded to each other to form a ring together with the atoms to which they are bonded,
R² represents an alkyl group having n^{R2} carbon atoms, and the group may have a substituent; and n^{R2} represents an integer of 1 or more and 15 or less,
R³ represents a cycloalkyl group, an alkoxy group, a cycloalkoxy group, an aryl group, an aryloxy group, or a monovalent heterocyclic group, a substituted amino group, a halogen atom, or an alkyl group having n^{R3} carbon atoms, and these groups may each have a substituent; and n^{R3} represents an integer of 1 or more and 15 or less;
**characterised in that** n^{R1} + n^{R2} is 7 or more and 30 or less.

2. The light emitting device according to claim 1, wherein the metal complex represented by formula (1) is a metal complex represented by formula (1-1), 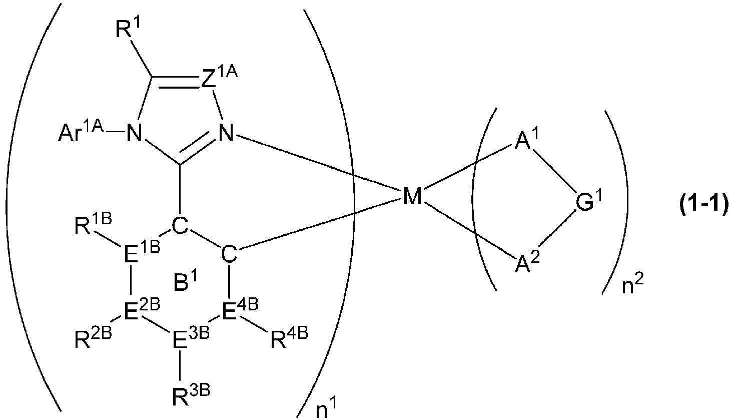 wherein,
M, Z^{1A}, n¹, n², R¹, Ar^{1A}, and A¹-G¹-A² represent the same meanings as described above,
the ring B¹ represents a benzene ring, a pyridine ring, or a diazabenzene ring, and E^{1B}, E^{2B}, E^{3B}, and E^{4B} each independently represent a nitrogen atom or a carbon atom; when there are a plurality of E^{1B}, E^{2B}, E^{3B}, and E^{4B}, they may be the same or different at each occurrence; when E^{1B} is a nitrogen atom, R^{1B} is absent; when E^{2B} is a nitrogen atom, R^{2B} is absent; when E^{3B} is a nitrogen atom, R^{3B} is absent; and when E^{4B} is a nitrogen atom, R^{4B} is absent, and
R^{1B}, R^{2B}, R^{3B}, and R^{4B} each independently represent a hydrogen atom, an alkyl group, a cycloalkyl group, an alkoxy group, a cycloalkoxy group, an aryl group, an aryloxy group, a monovalent heterocyclic ring, a substituted amino group, or a halogen atom, and these groups may each have a substituent; when there are a plurality of R^{1B}, R^{2B}, R^{3B}, and R^{4B}, they may be the same or different at each occurrence; and R^{1B} and R^{2B}, R^{2B} and R^{3B}, and R^{3B} and R^{4B} may each be bonded to each other to form a ring together with the atoms to which they are bonded.

3. The light emitting device according to claim 2, wherein the metal complex represented by formula (1-1) is a metal complex represented by formula (1-2), 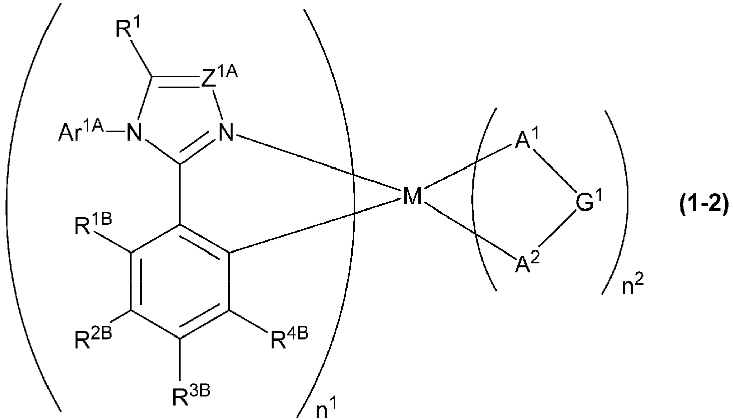 wherein,
M, Z^{1A}, n¹, n², R¹, Ar^{1A}, A¹-G¹-A², R^{1B}, R^{2B}, R^{3B}, and R^{4B} represent the same meanings as described above.

4. The light emitting device according to any one of claims 1 to 3, wherein the group represented by formula (Ar-1A) is a group represented by formula (Ar-2A), 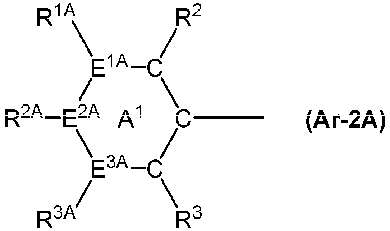 wherein,
R² and R³ represent the same meanings as described above,
the ring A¹ represents a benzene ring, a pyridine ring, or a diazabenzene ring, and E^{1A}, E^{2A}, and E^{3A} each independently represent a nitrogen atom or a carbon atom; when E^{1A} is a nitrogen atom, R^{1A} is absent; when E^{2A} is a nitrogen atom, R^{2A} is absent; and when E^{3A} is a nitrogen atom, R^{3A} is absent, and
R^{1A}, R^{2A}, and R^{3A} each independently represent a hydrogen atom, an alkyl group, a cycloalkyl group, an alkoxy group, a cycloalkoxy group, an aryl group, an aryloxy group, a monovalent heterocyclic ring, a substituted amino group, or a halogen atom, and these groups may each have a substituent; and R^{1A} and R^{2A}, and R^{2A} and R^{3A} may each be bonded to each other to form a ring together with the atoms to which they are bonded.

5. The light emitting device according to claim 4, wherein the group represented by formula (Ar-2A) is a group represented by formula (Ar-3A), 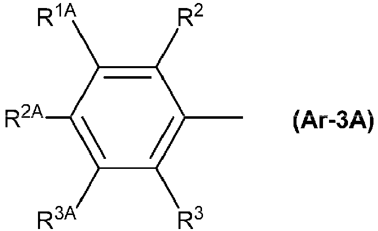 wherein,
R², R³ R^{1A}, R^{2A}, and R^{3A} represent the same meanings as described above.

6. The light emitting device according to any one of claims 1 to 5, wherein the light emitting layer further comprises a compound represented by formula (H-1), 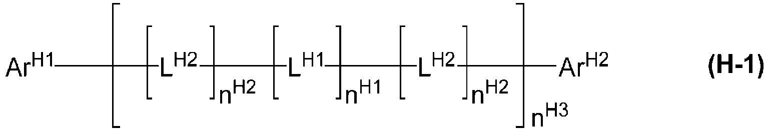 wherein,
Ar^{H1} and Ar^{H2} each independently represent an aryl group or a monovalent heterocyclic group, and these groups may each have a substituent,
n^{H1} and n^{H2} each independently represent 0 or 1; when there are a plurality of n^{H1}, they may be the same or different; and the plurality of n^{H2} may be the same or different;
n^{H3} represents an integer of 0 or more and 10 or less,
L^{H1} represents an arylene group, a divalent heterocyclic group, or a group represented by -[C(R^{H11})₂]n^{H11}-, and these groups may each have a substituent; when there are a plurality of L^{H1}, they may be the same or different; n^{H11} represents an integer of 1 or more and 10 or less; R^{H11} represents a hydrogen atom, an alkyl group, a cycloalkyl group, an alkoxy group, a cycloalkoxy group, an aryl group, or a monovalent heterocyclic group, and these groups may each have a substituent; and the plurality of R^{H11} may be the same or different and may be bonded to each other to form a ring together with the carbon atom to which they are bonded, and
L^{H2} represents a group represented by -N(-L^{H21}-R^{H21})-; when there are a plurality of L^{H2}, they may be the same or different; L^{H21} represents a single bond, an arylene group, or a divalent heterocyclic group, and these groups may each have a substituent; R^{H21} represents a hydrogen atom, an alkyl group, a cycloalkyl group, an aryl group, or a monovalent heterocyclic group, and these groups may each have a substituent.

7. The light emitting device according to any one of claims 1 to 6, wherein the light emitting layer further comprises at least one selected from the group consisting of a hole transporting material, a hole injecting material, an electron transporting material, an electron injecting material, a light emitting material, and an antioxidant.

8. A metal complex represented by formula (1), 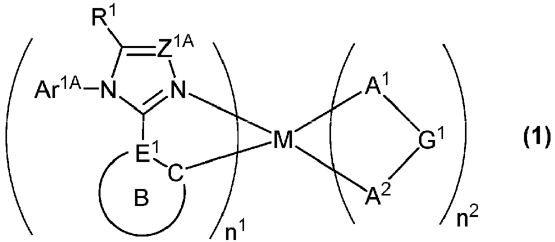 wherein,
M represents a rhodium atom, a palladium atom, an iridium atom or a platinum atom,
when M is a rhodium atom or an iridium atom, n¹ is 2 or 3; when M is a palladium atom or a platinum atom, n¹ is 2,
n² represents an integer of 0 or more, and n¹ + n² is 2 or 3,
when M is a rhodium atom or an iridium atom, n¹ + n² is 3, and when M is a palladium atom or a platinum atom, n¹ + n² is 2,
E¹ represents a carbon atom or a nitrogen atom; and when there are a plurality of E¹, they may be the same or different,
the ring B represents an aromatic hydrocarbon ring or an aromatic heterocyclic ring, and these rings may each have a substituent; when there are a plurality of the substituents, they may be bonded to each other to form a ring together with the atoms to which they are bonded; and when there are a plurality of the ring B, they may be the same or different,
Z^{1A} represents a group represented by =N- or a group represented by =C(R^{Z1A})-; when there are a plurality of Z^{1A}, they may be the same or different; and R^{Z1A} represents a hydrogen atom, an alkyl group, a cycloalkyl group, an alkoxy group, a cycloalkoxy group, an aryl group, an aryloxy group, or a monovalent heterocyclic group, a substituted amino group, or a halogen atom, and these groups may each have a substituent,
R¹ represents a tertiary alkyl group having n^{R1} carbon atoms, and the group may have a substituent; when there are a plurality of R¹, they may be the same or different; and n^{R1} represents an integer of 4 or more and 15 or less,
Ar^{1A} represents a group represented by formula (Ar-1A); and when there are a plurality of Ar^{1A}, they may be the same or different, and
A¹-G¹-A² represents an anionic bidentate ligand; A¹ and A² each independently represent a carbon atom, an oxygen atom or a nitrogen atom, and these atoms may each be an atom constituting a ring; G¹ represents a single bond or an atomic group constituting the bidentate ligand together with A¹ and A²; and when there are a plurality of A¹-G¹-A², they may be the same or different, 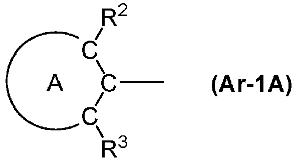 wherein,
the ring A represents an aromatic hydrocarbon ring or an aromatic heterocyclic ring, and these rings may each have a substituent; and when there are a plurality of the substituents, they may be bonded to each other to form a ring together with the atoms to which they are bonded,
R² represents an alkyl group having n^{R2} carbon atoms, and the group may have a substituent; and n^{R2} represents an integer of 1 or more and 15 or less, and
R³ represents a cycloalkyl group, an alkoxy group, a cycloalkoxy group, an aryl group, an aryloxy group, or a monovalent heterocyclic group, a substituted amino group, a halogen atom, or an alkyl group having n^{R3} carbon atoms, and these groups may each have a substituent; and n^{R3} represents an integer of 1 or more and 15 or less;
**characterised in that** n^{R1} + n^{R2} is 7 or more and 30 or less.

9. A composition comprising the metal complex according to claim 8 and a solvent.

## Patentansprüche

1. Lichtemittierende Vorrichtung, die Folgendes umfasst:
eine Anode;
eine Kathode; und
eine lichtemittierende Schicht, die zwischen der Anode und der Kathode vorgesehen ist,
wobei die lichtemittierende Schicht einen durch die Formel (1) dargestellten Metallkomplex umfasst, 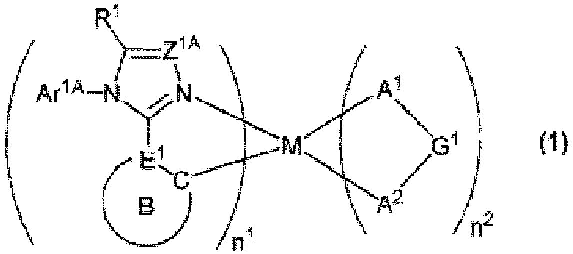 wobei,
M ein Rhodiumatom, ein Palladiumatom, ein Iridiumatom oder ein Platinatom darstellt,
wenn M ein Rhodiumatom oder ein Iridiumatom ist, n¹ 2 oder 3 ist; wenn M ein Palladiumatom oder ein Platinatom ist, n¹ 2 ist,
n² eine ganze Zahl von 0 oder mehr darstellt und n¹ + n² 2 oder 3 ist,
wenn M ein Rhodiumatom oder ein Iridiumatom ist, n¹ + n² 3 ist, und wenn M ein Palladiumatom oder ein Platinatom ist, n¹ + n² 2 ist,
E¹ ein Kohlenstoffatom oder ein Stickstoffatom darstellt; und wenn es mehrere E¹ gibt, sie gleich oder verschieden sein können,
der Ring B einen aromatischen Kohlenwasserstoffring oder einen aromatischen heterocyclischen Ring darstellt, und diese Ringe jeweils einen Substituenten aufweisen können; wenn es mehrere Substituenten gibt, sie miteinander verbunden sein können, um zusammen mit den Atomen, an die sie gebunden sind, einen Ring zu bilden; und wenn es mehrere Ringe B gibt, sie gleich oder verschieden sein können,
Z^{1A} eine Gruppe, dargestellt durch =N- oder eine Gruppe, dargestellt durch =C(R^{Z1A})-, darstellt; wenn es mehrere Z^{1A} gibt, sie gleich oder verschieden sein können; und R^{Z1A} ein Wasserstoffatom, eine Alkylgruppe, eine Cycloalkylgruppe, eine Alkoxygruppe, eine Cycloalkoxygruppe, eine Arylgruppe, eine Aryloxygruppe oder eine einwertige heterocyclische Gruppe, eine substituierte Aminogruppe oder ein Halogenatom darstellt, wobei diese Gruppen jeweils einen Substituenten aufweisen können,
R¹ eine tertiäre Alkylgruppe mit n^{R1} Kohlenstoffatomen darstellt, und die Gruppe einen Substituenten aufweisen kann; wenn es mehrere R¹ gibt, sie gleich oder verschieden sein können; und n^{R1} eine ganze Zahl von 4 oder mehr und 15 oder weniger darstellt,
Ar^{1A} eine Gruppe der Formel (Ar-1A) darstellt; und wenn es mehrere Ar^{1A} gibt, sie gleich oder verschieden sein können, und
A¹-G¹-A² einen anionischen zweizähnigen Liganden darstellt; A¹ und A² jeweils unabhängig voneinander ein Kohlenstoffatom, ein Sauerstoffatom oder ein Stickstoffatom darstellen, und diese Atome jeweils ein Atom sein können, das einen Ring bildet; G¹ eine Einfachbindung oder eine Atomgruppe darstellt, die den zweizähnigen Liganden zusammen mit A¹ und A² bildet; und wenn es mehrere A¹-G¹-A² gibt, sie gleich oder verschieden sein können, 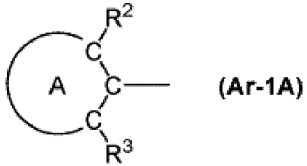 wobei,
der Ring A einen aromatischen Kohlenwasserstoffring oder einen aromatischen heterocyclischen Ring darstellt, und diese Ringe jeweils einen Substituenten aufweisen können; ujnd wenn es mehrere Substituenten gibt, sie miteinander verbunden sein können, um zusammen mit den Atomen, an die sie gebunden sind, einen Ring zu bilden,
R² eine Alkylgruppe mit n^{R2} Kohlenstoffatomen darstellt und die Gruppe einen Substituenten aufweisen kann; und n^{R2} eine ganze Zahl von 1 oder mehr und 15 oder weniger darstellt,
R³ eine Cycloalkylgruppe, eine Alkoxygruppe, eine Cycloalkoxygruppe, eine Arylgruppe, eine Aryloxygruppe oder eine einwertige heterocyclische Gruppe, eine substituierte Aminogruppe, ein Halogenatom oder eine Alkylgruppe mit n^{R3} Kohlenstoffatomen darstellt, und diese Gruppen jeweils einen Substituenten aufweisen können; und n^{R3} eine ganze Zahl von 1 oder mehr und 15 oder weniger darstellt; **dadurch gekennzeichnet, dass** n^{R1} + n^{R2} 7 oder mehr und 30 oder weniger ist.

2. Lichtemittierende Vorrichtung nach Anspruch 1,
wobei der durch Formel (1) dargestellte Metallkomplex ein durch Formel (1-1) dargestellter Metallkomplex ist, 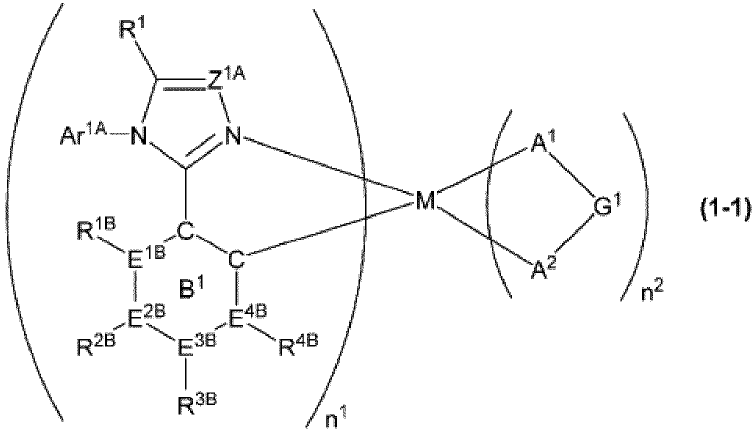 wobei,
M, Z^{1A}, n¹, n², R¹, Ar^{1A} und A¹-G¹-A² die gleichen Bedeutungen wie oben beschrieben haben,
der Ring B¹ einen Benzolring, einen Pyridinring oder einen Diazabenzolring darstellt, und
E^{1B}, E^{2B}, E^{3B} und E^{4B} jeweils unabhängig voneinander ein Stickstoffatom oder ein Kohlenstoffatom darstellen; wenn mehrere E^{1B}, E^{2B}, E^{3B} und E^{4B} vorhanden sind, sie bei jedem Auftreten gleich oder verschieden sein können; wenn E^{1B} ein Stickstoffatom ist, Rm abwesend ist; wenn E^{2B} ein Stickstoffatom ist, R^{2B} abwesend ist; wenn E^{3B} ein Stickstoffatom ist, R^{3B} abwesend ist; und wenn E^{4B} ein Stickstoffatom ist, R^{4B} abwesend ist, und
R^{1B}, R^{2B}, R^{3B} und R^{4B} jeweils unabhängig voneinander ein Wasserstoffatom, eine Alkylgruppe, eine Cycloalkylgruppe, eine Alkoxygruppe, eine Cycloalkoxygruppe, eine Arylgruppe, eine Aryloxygruppe, einen einwertigen heterocyclischen Ring, eine substituierte Aminogruppe oder ein Halogenatom darstellen, wobei diese Gruppen jeweils einen Substituenten aufweisen können; wenn es mehrere R^{1B}, R^{2B}, R^{3B} und R^{4B} gibt, sie bei jedem Auftreten gleich oder verschieden sein können; und
R^{1B} und R^{2B}, R^{2B} und R^{3B} sowie R^{3B} und R^{4B} jeweils aneinander gebunden sein können, um zusammen mit den Atomen, an die sie gebunden sind, einen Ring zu bilden.

3. Lichtemittierende Vorrichtung nach Anspruch 2,
wobei der durch Formel (1-1) dargestellte Metallkomplex ein durch Formel (1-2) dargestellter Metallkomplex ist, 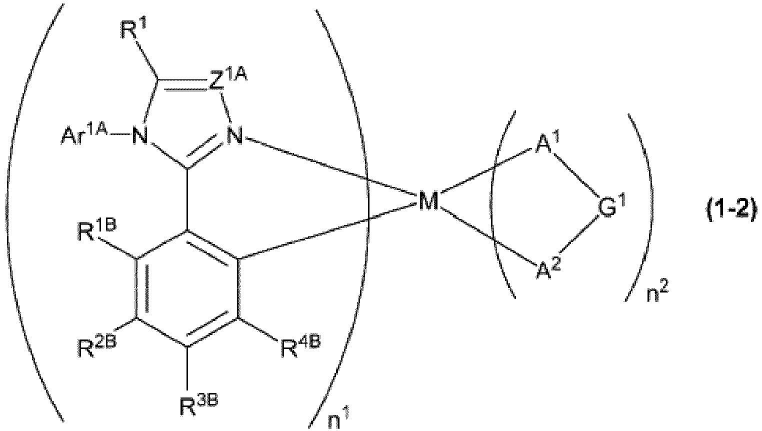 wobei,
M, Z^{1A}, n¹, n², R¹, Ar^{1A}, A¹-G¹-A², R^{1B}, R^{2B}, R^{3B} und R^{4B} die gleichen Bedeutungen wie oben beschrieben haben.

4. Lichtemittierende Vorrichtung nach einem der Ansprüche 1 bis 3, wobei die durch die Formel (Ar-1A) dargestellte Gruppe eine durch die Formel (Ar-2A) dargestellte Gruppe ist, 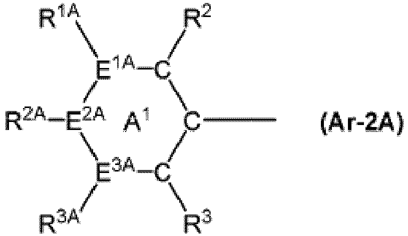 wobei,
R² und R³ die gleichen Bedeutungen haben wie oben beschrieben,
der Ring A¹ einen Benzolring, einen Pyridinring oder einen Diazabenzolring darstellt, und E^{1A}, E^{2A} und E^{3A} jeweils unabhängig voneinander ein Stickstoffatom oder ein Kohlenstoffatom darstellen; wenn E^{1A} ein Stickstoffatom ist, R^{1A} abwesend ist; wenn E^{2A} ein Stickstoffatom ist, R^{2A} abwesend ist; und wenn E^{3A} ein Stickstoffatom ist, R^{3A} abwesend ist, und
R^{1A}, R^{2A} und R^{3A} jeweils unabhängig voneinander ein Wasserstoffatom, eine Alkylgruppe, eine Cycloalkylgruppe, eine Alkoxygruppe, eine Cycloalkoxygruppe, eine Arylgruppe, eine Aryloxygruppe, einen einwertigen heterocyclischen Ring, eine substituierte Aminogruppe oder ein Halogenatom darstellen, und diese Gruppen jeweils einen Substituenten aufweisen können; und R^{1A} und R^{2A} und R^{2A} und R^{3A} jeweils aneinander gebunden sein können, um zusammen mit den Atomen, an die sie gebunden sind, einen Ring zu bilden.

5. Lichtemittierende Vorrichtung nach Anspruch 4, wobei die durch die Formel (Ar-2A) dargestellte Gruppe eine durch die Formel (Ar-3A) dargestellte Gruppe ist, 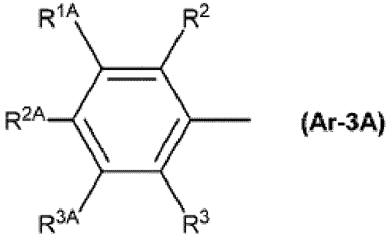 wobei,
R², R³, R^{1A}, R^{2A} und R^{3A} die gleichen Bedeutungen haben, wie oben beschrieben.

6. Lichtemittierende Vorrichtung nach einem der Ansprüche 1 bis 5, wobei die lichtemittierende Schicht ferner eine Verbindung der Formel (H-1) umfasst, 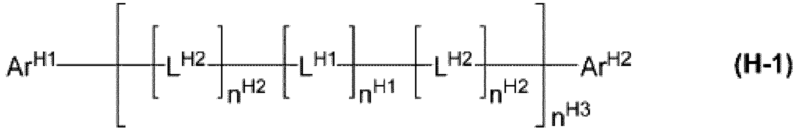 wobei,
Ar^{H1} und Ar^{H2} jeweils unabhängig voneinander eine Arylgruppe oder eine einwertige heterocyclische Gruppe darstellen, und diese Gruppen jeweils einen Substituenten aufweisen können,
n^{H1} und n^{H2} jeweils unabhängig voneinander 0 oder 1 darstellen; wenn es mehrere n^{H1} gibt, sie gleich oder verschieden sein können; und die mehreren n^{H2} gleich oder verschieden sein können;
n^{H3} eine ganze Zahl von 0 oder mehr und 10 oder weniger darstellt,
L^{H1} eine Arylengruppe, eine zweiwertige heterocyclische Gruppe oder eine durch -[C(R^{H11})₂]n^{H11}- dargestellte Gruppe darstellt, und diese Gruppen jeweils einen Substituenten aufweisen können; wenn es mehrere L^{H1} gibt, sie gleich oder verschieden sein können; n^{H11} eine ganze Zahl von 1 oder mehr und 10 oder weniger darstellt, R^{H11} ein Wasserstoffatom, eine Alkylgruppe, eine Cycloalkylgruppe, eine Alkoxygruppe, eine Cycloalkoxygruppe, eine Arylgruppe oder eine einwertige heterocyclische Gruppe darstellt, und diese Gruppen jeweils einen Substituenten aufweisen können; und die mehreren R^{H11} gleich oder verschieden sein können und miteinander verbunden sein können, um zusammen mit dem Kohlenstoffatom, an das sie gebunden sind, einen Ring zu bilden, und
L^{H2} eine Gruppe darstellt, die durch -N(-L^{H21}-R^{H21})- dargestellt wird; wenn es mehrere L^{H2} gibt, sie gleich oder verschieden sein können; L^{H21} eine Einfachbindung, eine Arylengruppe oder eine zweiwertige heterocyclische Gruppe darstellt, und diese Gruppen jeweils einen Substituenten aufweisen können; R^{H21} ein Wasserstoffatom, eine Alkylgruppe, eine Cycloalkylgruppe, eine Arylgruppe oder eine einwertige heterocyclische Gruppe darstellt, und diese Gruppen jeweils einen Substituenten aufweisen können.

7. Lichtemittierende Vorrichtung nach einem der Ansprüche 1 bis 6, wobei die lichtemittierende Schicht ferner mindestens eines umfasst, das ausgewählt ist aus der Gruppe bestehend aus einem Lochtransportmaterial, einem Lochinjektionsmaterial, einem Elektronentransportmaterial, einem Elektroneninjektionsmaterial, einem lichtemittierenden Material und einem Antioxidans.

8. Metallkomplex, dargestellt durch die Formel (1), 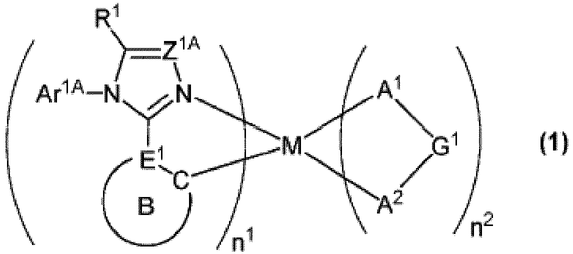 wobei,
M ein Rhodiumatom, ein Palladiumatom, ein Iridiumatom oder ein Platinatom darstellt,
wenn M ein Rhodiumatom oder ein Iridiumatom ist, n¹ 2 oder 3 ist; wenn M ein Palladiumatom oder ein Platinatom ist, n¹ 2 ist,
n² eine ganze Zahl von 0 oder mehr darstellt und n¹ + n² 2 oder 3 ist,
wenn M ein Rhodiumatom oder ein Iridiumatom ist, n¹ + n² 3 ist, und wenn M ein Palladiumatom oder ein Platinatom ist, n¹ + n² 2 ist,
E¹ ein Kohlenstoffatom oder ein Stickstoffatom darstellt; und wenn es mehrere E¹ gibt, sie gleich oder verschieden sein können,
der Ring B einen aromatischen Kohlenwasserstoffring oder einen aromatischen heterocyclischen Ring darstellt, und diese Ringe jeweils einen Substituenten aufweisen können; wenn es mehrere Substituenten gibt, sie miteinander verbunden sein können, um zusammen mit den Atomen, an die sie gebunden sind, einen Ring zu bilden; und wenn es mehrere Ringe B gibt, sie gleich oder verschieden sein können,
Z^{1A} eine Gruppe, dargestellt durch =N- oder eine Gruppe, dargestellt durch =C(R^{Z1A})-, darstellt; wenn es mehrere Z^{1A} gibt, sie gleich oder verschieden sein können; und R^{Z1A} ein Wasserstoffatom, eine Alkylgruppe, eine Cycloalkylgruppe, eine Alkoxygruppe, eine Cycloalkoxygruppe, eine Arylgruppe, eine Aryloxygruppe oder eine einwertige heterocyclische Gruppe, eine substituierte Aminogruppe oder ein Halogenatom darstellt, und diese Gruppen jeweils einen Substituenten aufweisen können,
R¹ eine tertiäre Alkylgruppe mit n^{R1} Kohlenstoffatomen darstellt, und die Gruppe einen Substituenten aufweisen kann; wenn mehrere R¹ vorhanden sind, sie gleich oder verschieden sein können; und n^{R1} eine ganze Zahl von 4 oder mehr und 15 oder weniger darstellt,
Ar^{1A} eine Gruppe der Formel (Ar-1A) darstellt; und wenn es mehrere Ar^{1A} gibt, sie gleich oder verschieden sein können, und
A¹-G¹-A² einen anionischen zweizähnigen Liganden darstellt; A¹ und A² jeweils unabhängig voneinander ein Kohlenstoffatom, ein Sauerstoffatom oder ein Stickstoffatom darstellen, und diese Atome jeweils ein Atom sein können, das einen Ring bildet; G¹ eine Einfachbindung oder eine Atomgruppe darstellt, die den zweizähnigen Liganden zusammen mit A¹ und A² bildet; und wenn es mehrere A¹-G¹-A² gibt, sie gleich oder verschieden sein können, 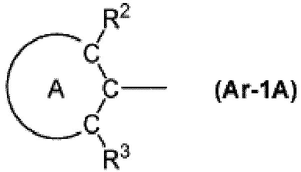 wobei,
der Ring A einen aromatischen Kohlenwasserstoffring oder einen aromatischen heterocyclischen Ring darstellt, und diese Ringe jeweils einen Substituenten aufweisen können; ujnd wenn es mehrere Substituenten gibt, sie miteinander verbunden sein können, um zusammen mit den Atomen, an die sie gebunden sind, einen Ring zu bilden,
R² eine Alkylgruppe mit n^{R2} Kohlenstoffatomen darstellt und die Gruppe einen Substituenten aufweisen kann; und n^{R2} eine ganze Zahl von 1 oder mehr und 15 oder weniger darstellt, und
R³ eine Cycloalkylgruppe, eine Alkoxygruppe, eine Cycloalkoxygruppe, eine Arylgruppe, eine Aryloxygruppe oder eine einwertige heterocyclische Gruppe, eine substituierte Aminogruppe, ein Halogenatom oder eine Alkylgruppe mit n^{R3} Kohlenstoffatomen darstellt, und diese Gruppen jeweils einen Substituenten aufweisen können; und n^{R3} eine ganze Zahl von 1 oder mehr und 15 oder weniger darstellt;
**dadurch gekennzeichnet, dass** n^{R1} + n^{R2} 7 oder mehr und 30 oder weniger ist.

9. Zusammensetzung, die den Metallkomplex nach Anspruch 8 und ein Lösungsmittel umfasst.

## Revendications

1. Dispositif électroluminescent, comprenant :
une anode ;
une cathode; et
une couche électroluminescente disposée entre l'anode et la cathode,
dans lequel la couche électroluminescente comprend un complexe métallique représenté par la formule (1), 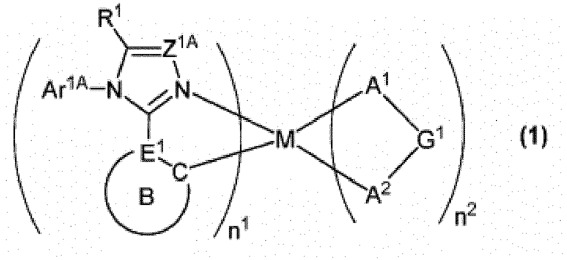 dans laquelle
M représente un atome de rhodium, un atome de palladium, un atome d'iridium ou un atome de platine,
lorsque M est un atome de rhodium ou un atome d'iridium, n¹ vaut 2 ou 3 ;
lorsque M est un atome de palladium ou un atome de platine, n¹ vaut 2,
n² représente un entier supérieur ou égal à 0, et n¹ + n² vaut 2 ou 3,
lorsque M est un atome de rhodium ou un atome d'iridium, n¹ + n² vaut 3, et
lorsque M est un atome de palladium ou un atome de platine, n¹ + n² vaut 2,
E¹ représente un atome de carbone ou un atome d'azote ; et lorsqu'il y a plusieurs E¹, ils peuvent être identiques ou différents,
le cycle B représente un cycle hydrocarboné aromatique ou un cycle hétérocyclique aromatique, et ces cycles peuvent chacun avoir un substituant ; lorsqu'il y a plusieurs substituants, ils peuvent
être liés les uns aux autres pour former un cycle avec les atomes auxquels ils sont liés ; et lorsqu'il y a plusieurs cycles B, ils peuvent être identiques ou différents,
Z^{1A} représente un groupe représenté par =N- ou un groupe représenté par =C(R^{Z1A})- ; lorsqu'il y a plusieurs Z^{1A}, ils peuvent être identiques ou différents ; et R^{Z1A} représente un atome d'hydrogène, un groupe alkyle, un groupe cycloalkyle, un groupe alcoxy, un groupe cycloalcoxy, un groupe aryle, un groupe aryloxy, ou un groupe hétérocyclique monovalent, un groupe amino substitué, ou un atome d'halogène, et ces groupes peuvent chacun avoir un substituant,
R¹ représente un groupe alkyle tertiaire ayant n^{R1} atomes de carbone, et le groupe peut avoir un substituant ; lorsqu'il y a plusieurs R¹, ils peuvent être identiques ou différents ; et n^{R1} représente un entier de 4 ou plus et 15 ou moins,
Ar^{1A} représente un groupe représenté par la formule (Ar-1A) ; et lorsqu'il y a plusieurs Ar^{1A}, ils peuvent être identiques ou différents, et
A¹-G¹-A² représente un ligand anionique bidenté ; A¹ et A² représentent chacun indépendamment un atome de carbone, un atome d'oxygène, ou un atome d'azote, et ces atomes peuvent être chacun un atome constituant un cycle ; G¹ représente une liaison simple ou un groupe atomique constituant le ligand bidenté avec A¹ et A² ; et lorsqu'il y a plusieurs A¹-G¹-A²,
ils peuvent être identiques ou différents, 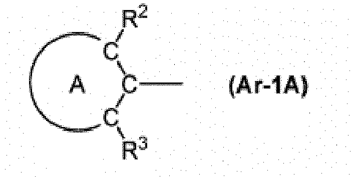
dans laquelle,
le cycle A représente un cycle hydrocarboné aromatique ou un cycle hétérocyclique aromatique, et ces cycles peuvent chacun avoir un substituant ; et lorsqu'il y a plusieurs substituants, ils peuvent être liés les uns aux autres pour former un cycle avec les atomes auxquels ils sont liés,
R² représente un groupe alkyle ayant n^{R2} atomes de carbone, et le groupe peut avoir un substituant ; et n^{R2} représente un entier de 1 ou plus et 15 ou moins,
R³ représente un groupe cycloalkyle, un groupe alcoxy, un groupe cycloalcoxy, un groupe aryle, un groupe aryloxy, ou un groupe hétérocyclique monovalent, un groupe amino substitué, un atome d'halogène, ou un groupe alkyle ayant n^{R3} atomes de carbone, et ces groupes peuvent chacun avoir un substituant ; et n^{R3} représente un entier de 1 ou plus et 15 ou moins ;
**caractérisé en ce que** n^{R1} + n^{R2} vaut 7 ou plus et 30 ou moins.

2. Dispositif électroluminescent selon la revendication 1, dans lequel le complexe métallique représenté par la formule (1) est un complexe métallique représenté par la formule (1-1), 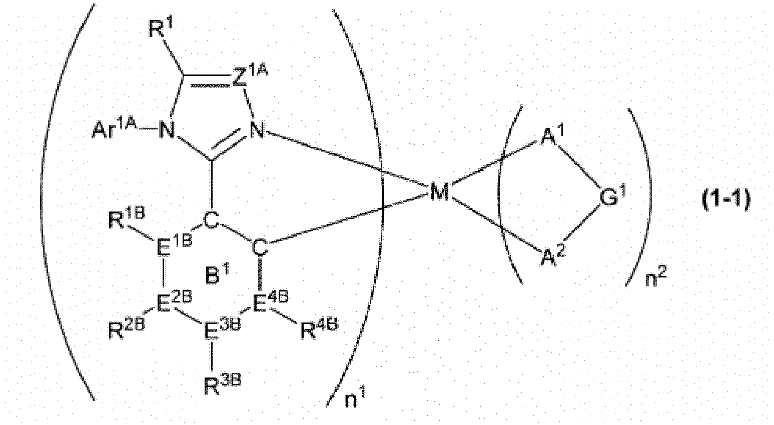 dans laquelle M, Z^{1A}, n¹, n², R¹, Ar^{1A} et A¹-G¹-A² représentent les mêmes significations que décrites ci-dessus,
le cycle B¹ représente un cycle benzène, un cycle pyridine ou un cycle diazabenzène, et E^{1B}, E^{2B}, E^{3B} et E^{4B} représentent chacun indépendamment un atome d'azote ou un atome de carbone ; lorsqu'il y a plusieurs E^{1B}, E^{2B}, E^{3B} et E^{4B}, ils peuvent être identiques ou différents à chaque occurrence ; lorsque E^{1B} est un atome d'azote, R^{1B} est absent ; lorsque E^{2B} est un atome d'azote, R^{2B} est absent ; lorsque E^{3B} est un atome d'azote, R^{3B} est absent ; et lorsque E^{4B} est un atome d'azote, R^{4B} est absent, et
R^{1B}, R^{2B}, R^{3B} et R^{4B} représentent chacun indépendamment un atome d'hydrogène, un groupe alkyle, un groupe cycloalkyle, un groupe alcoxy, un groupe cycloalcoxy, un groupe aryle, un groupe aryloxy, un cycle hétérocyclique monovalent, un groupe amino substitué ou un atome d'halogène, et ces groupes peuvent chacun avoir un substituant ; lorsqu'il y a plusieurs R^{1B}, R^{2B}, R^{3B} et R^{4B}, ils peuvent être identiques ou différents à chaque occurrence ; et R^{1B} et R^{2B}, R^{2B} et R^{3B}, et R^{3B} et R^{4B} peuvent chacun être liés l'un à l'autre pour former un cycle avec les atomes auxquels ils sont liés.

3. Dispositif électroluminescent selon la revendication 2, dans lequel le complexe métallique représenté par la formule (1-1) est un complexe métallique représenté par la formule (1-2), 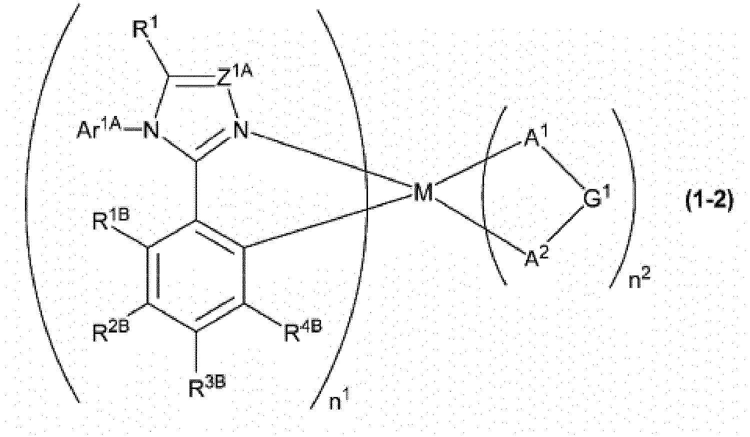 dans laquelle,
M, Z^{1A}, n¹, n², R¹, Ar^{1A}, A¹-G¹-A² R^{1B}, R^{2B}, R^{3B} et R^{4B} représentent les mêmes significations que celles décrites ci-dessus.

4. Dispositif électroluminescent selon l'une quelconque des revendications 1 à 3, dans lequel le groupe représenté par la formule (Ar-1A) est un groupe représenté par la formule (Ar-2A), 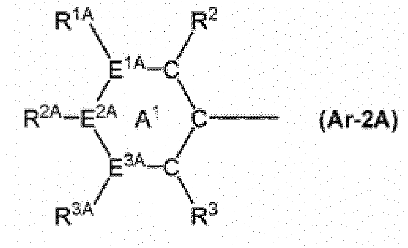 dans laquelle
R² et R³ représentent les mêmes significations que celles décrites ci-dessus,
le cycle A¹ représente un cycle benzène, un cycle pyridine ou un cycle diazabenzène, et E^{1A}, E^{2A} et E^{3A} représentent chacun indépendamment un atome d'azote ou un atome de carbone ; lorsque E^{1A} est un atome d'azote, R^{1A} est absent ; lorsque E^{2A} est un atome d'azote, R^{2A} est absent ; et lorsque E^{3A} est un atome d'azote, R^{3A} est absent, et
R^{1A}, R^{2A} et R^{3A} représentent chacun indépendamment un atome d'hydrogène, un groupe alkyle, un groupe cycloalkyle, un groupe alcoxy, un groupe cycloalcoxy, un groupe aryle, un groupe aryloxy, un cycle hétérocyclique monovalent, un groupe amino substitué ou un atome d'halogène, et ces groupes peuvent chacun avoir un substituant ; et R^{1A} et R^{2A}, et R^{2A} et R^{3A} peuvent chacun être liés l'un à l'autre pour former un cycle avec les atomes auxquels ils sont liés.

5. Dispositif électroluminescent selon la revendication 4, dans lequel le groupe représenté par la formule (Ar-2A) est un groupe représenté par la formule (Ar-3A), 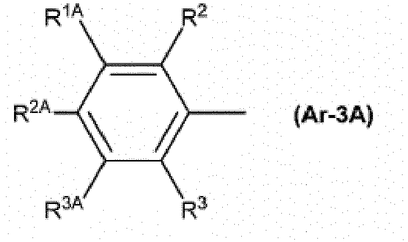 dans laquelle R², R³, R^{1A}, R^{2A} et R^{3A} représentent les mêmes significations que celles décrites ci-dessus.

6. Dispositif électroluminescent selon l'une quelconque des revendications 1 à 5, dans lequel la couche électroluminescente comprend en outre un composé représenté par la formule (H-1), 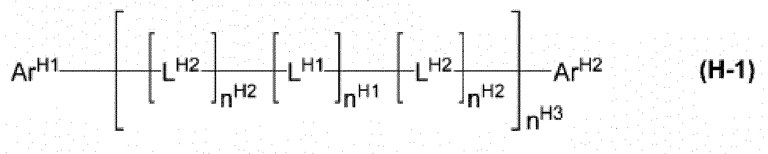 dans laquelle
Ar^{H1} et Ar^{H2} représentent chacun indépendamment un groupe aryle ou un groupe hétérocyclique monovalent, et ces groupes peuvent avoir chacun un substituant,
n^{H1} et n^{H2} représentent chacun indépendamment 0 ou 1 ; lorsqu'il y a plusieurs n^{H1}, ils peuvent être identiques ou différents ; et les plusieurs n^{H2} peuvent être identiques ou différents ;
n^{H3} représente un entier de 0 ou plus et 10 ou moins,
L^{H1} représente un groupe arylène, un groupe hétérocyclique divalent ou un groupe représenté par -[C(R^{H11})₂]n^{H11}-, et ces groupes peuvent chacun avoir un substituant ; lorsqu'il y a plusieurs L^{H1}, ils peuvent être identiques ou différents ; n^{H11} représente un nombre entier de 1 ou plus et 10 ou moins ; R^{H11} représente un atome d'hydrogène, un groupe alkyle, un groupe cycloalkyle, un groupe alcoxy, un groupe cycloalcoxy, un groupe aryle ou un groupe hétérocyclique monovalent, et ces groupes peuvent chacun avoir un substituant ; et les plusieurs R^{H11} peuvent être identiques ou différents et peuvent être liés les uns aux autres pour former un cycle avec l'atome de carbone auquel ils sont liés, et
L^{H2} représente un groupe représenté par -N(-L^{H21}-R^{H21})- ; lorsqu'il y a plusieurs L^{H2}, ils peuvent être identiques ou différents ; L^{H21} représente une liaison simple, un groupe arylène ou un groupe hétérocyclique divalent, et ces groupes peuvent chacun avoir un substituant ; R^{H21} représente un atome d'hydrogène, un groupe alkyle, un groupe cycloalkyle, un groupe aryle ou un groupe hétérocyclique monovalent, et ces groupes peuvent chacun avoir un substituant.

7. Dispositif électroluminescent selon l'une quelconque des revendications 1 à 6, dans lequel la couche électroluminescente comprend en outre au moins un élément choisi dans le groupe constitué par un matériau de transport de trous, un matériau d'injection de trous, un matériau de transport d'électrons, un matériau d'injection d'électrons, un matériau électroluminescent et un antioxydant.

8. Complexe métallique représenté par la formule (1), 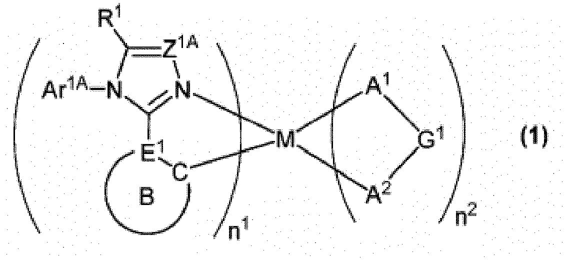
M représente un atome de rhodium, un atome de palladium, un atome d'iridium ou un atome de platine,
lorsque M est un atome de rhodium ou un atome d'iridium, n¹ vaut 2 ou 3 ;
lorsque M est un atome de palladium ou un atome de platine, n¹ vaut 2,
n² représente un entier supérieur ou égal à 0, et n¹ + n² vaut 2 ou 3,
lorsque M est un atome de rhodium ou un atome d'iridium, n¹ + n² vaut 3, et
lorsque M est un atome de palladium ou un atome de platine, n¹ + n² vaut 2,
E¹ représente un atome de carbone ou un atome d'azote ; et lorsqu'il y a plusieurs E¹, ils peuvent être identiques ou différents,
le cycle B représente un cycle hydrocarboné aromatique ou un cycle hétérocyclique aromatique, et ces cycles peuvent chacun avoir un substituant ; lorsqu'il y a plusieurs substituants, ils peuvent être liés les uns aux autres pour former un cycle avec les atomes auxquels ils sont liés ; et lorsqu'il y a plusieurs cycles B, ils peuvent être identiques ou différents,
Z^{1A} représente un groupe représenté par =N- ou un groupe représenté par =C(R^{Z1A})- ; lorsqu'il y a plusieurs Z^{1A}, ils peuvent être identiques ou différents ; et R^{Z1A} représente un atome d'hydrogène, un groupe alkyle, un groupe cycloalkyle, un groupe alcoxy, un groupe cycloalcoxy, un groupe aryle, un groupe aryloxy, ou un groupe hétérocyclique monovalent, un groupe amino substitué, ou un atome d'halogène, et ces groupes peuvent chacun avoir un substituant,
R¹ représente un groupe alkyle tertiaire ayant n^{R1} atomes de carbone, et le groupe peut avoir un substituant ; lorsqu'il y a plusieurs R¹, ils peuvent être identiques ou différents ; et n^{R1} représente un entier de 4 ou plus et 15 ou moins,
Ar^{1A} représente un groupe représenté par la formule (Ar-1A) ; et lorsqu'il y a plusieurs Ar^{1A}, ils peuvent être identiques ou différents, et
A¹-G¹-A² représente un ligand anionique bidenté ; A¹ et A² représentent chacun indépendamment un atome de carbone, un atome d'oxygène, ou un atome d'azote, et ces atomes peuvent être chacun un atome constituant un cycle ; G¹ représente une liaison simple ou un groupe atomique constituant le ligand bidenté avec A¹ et A² ; et lorsqu'il y a plusieurs A¹-G¹-A², ils peuvent être identiques ou différents, 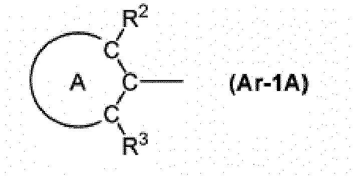 dans laquelle,
le cycle A représente un cycle hydrocarboné aromatique ou un cycle hétérocyclique aromatique, et ces cycles peuvent chacun avoir un substituant ; et lorsqu'il y a plusieurs substituants, ils peuvent être liés les uns aux autres pour former un cycle avec les atomes auxquels ils sont liés, R² représente un groupe alkyle ayant n^{R2} atomes de carbone, et le groupe peut avoir un substituant ; et n^{R2} représente un entier de 1 ou plus et 15 ou moins,
R³ représente un groupe cycloalkyle, un groupe alcoxy, un groupe cycloalcoxy, un groupe aryle, un groupe aryloxy, ou un groupe hétérocyclique monovalent, un groupe amino substitué, un atome d'halogène, ou un groupe alkyle ayant n^{R3} atomes de carbone, et ces groupes peuvent chacun avoir un substituant ; et n^{R3} représente un entier de 1 ou plus et 15 ou moins ;
**caractérisé en ce que** n^{R1} + n^{R2} vaut 7 ou plus et 30 ou moins.

9. Composition comprenant le complexe métallique selon la revendication 8 et un solvant.
